# EUROPEAN PATENT SPECIFICATION

(11) **EP 3 930 000 B1**
(45) Date of publication and mention of the grant of the patent: **22.01.2025**
(21) Application number: 21181363.9
(22) Date of filing: 24.06.2021
(51) Int. Cl.: H10K 71/00, H10K 59/80, H10K 59/88, H10K 71/16, H10K 71/50, H04M 1/02

(54) **DISPLAY DEVICE AND METHOD OF FABRICATING THE SAME**
ANZEIGEVORRICHTUNG UND VERFAHREN ZUR HERSTELLUNG DAVON
DISPOSITIF D'AFFICHAGE ET SON PROCÉDÉ DE FABRICATION

(30) Priority: 25.06.2020 KR 20200077796
(43) Date of publication of application: 29.12.2021
(73) Proprietor: Samsung Display Co., Ltd., Gyeonggi-do 17113 (KR)
(72) Inventor: KIM, Tae Oh, Suwon-si (KR); KIM, Byung Hoon, Hwaseong-si (KR); KO, Kyung Rok, Suwon-si (KR); KWON, Yong Hoon, Suwon-si (KR); KIM, Jung Hyun, Suwon-si (KR); PARK, June Hyoung, Seoul (KR); LEE, Hyun Ji, Gimhae-si (KR); JUNG, So Mi, Busan (KR)
(74) Representative: Marks & Clerk LLP

(56) References cited:
- US-A1- 2020 083 475
- US-A1- 2020 106 042
- US-A1- 2020 135 800

## Description

### BACKGROUND

### 1. Field

Aspects of example embodiments of the present disclosure relate to a display device and a method of fabricating the same.

### 2. Description of the Related Art

Electronic apparatuses for providing images to users, for example, such as a smartphone, a tablet PC, a digital camera, a laptop computer, a navigation device, a smart television, and the like, include display devices for displaying the images.

The display device includes a display panel, and various components for driving the display panel. Recently, various components for implementing various functions other than a screen display may be mounted on the display device. For example, a smartphone may be equipped with one or more optical elements, such as a camera, an infrared sensor, and/or the like, as examples of such components.

The display device may include an optical hole in order for the optical element to receive light. In this case, some members of the display device may be physically perforated to increase the transmittance of the optical holes.

The above information disclosed in this Background section is for enhancement of understanding of the background of the present disclosure, and therefore, it may contain information that does not constitute prior art. Examples of relevant prior art are to be found in the following applications: US 2020/135800 A1, US 2020/106042 A1 and US 2020/083475 A1.

### SUMMARY

One or more example embodiments of the present disclosure are directed to a display device in which a non-display area around (e.g., near or adjacent to) an optical hole is reduced, and a method of fabricating the same.

However, the aspects and features of the present disclosure are not limited thereto, and the above and other aspects and features of the present disclosure may become more apparent to one of ordinary skill in the art to which the present disclosure pertains by referencing the detailed description of the present disclosure below.

According to the invention as defined in independent claim 1, there is provided a display device comprising a first substrate; a second substrate facing the first substrate; a through hole penetrating the first substrate and the second substrate; a hole fusion pattern formed by fusing the first and second substrates to each other around the through hole; and an edge fusion pattern formed by fusing the first and second substrates to each other at an edge of the first substrate or the second substrate, wherein each of the first substrate and the second substrate comprises glass, wherein a width of the edge fusion pattern is greater than a width of the hole fusion pattern in a plan view, and wherein the display device further comprises a display area for displaying a screen, and a non-display area surrounding the display area. The display is characterized in that the through hole and the hole fusion pattern are at the display area, and the edge fusion pattern is at the non-display area, and wherein the display device further comprises a sub-hole fusion pattern configured to bond the first and second substrates to each other at the display area, the sub-hole fusion pattern surrounding at least one of the through hole or the hole fusion pattern.

In an example embodiment, the width of the hole fusion pattern may be in a range of 1/2 to 1/5 of the width of the edge fusion pattern.

In an example embodiment, the hole fusion pattern may be between the first substrate and the second substrate.

In an example embodiment, the display device may further include an active element layer between the first substrate and the second substrate, and the active element layer may not overlap with the through hole.

In an example embodiment, the hole fusion pattern may include a central portion including a plasma structure, and a peripheral portion surrounding the central portion.

In an example embodiment, a ratio of a thickness of the hole fusion pattern in a thickness direction to a width of the hole fusion pattern in a first direction perpendicular to the thickness direction may be greater than 1.9:1.

In an example embodiment, the width of the hole fusion pattern in the first direction may be less than or equal to 100 micro-meters (µm).

In an example embodiment, the hole fusion pattern may further include a long axis and a short axis crossing the long axis, and a width of one side of the long axis in a direction of the short axis may be different from a width of another side of the long axis in the direction of the short axis.

In an example embodiment, the other side of the long axis may be closer to the through hole than the one side of the long axis, and the width of the other side of the long axis may be greater than the width of the one side of the long axis.

In an example embodiment, the through hole and the hole fusion pattern may be spaced apart from each other, and the first substrate and the second substrate may be spaced apart from each other in a thickness direction at a region where the through hole and the hole fusion pattern are spaced apart from each other.

According to the invention as defined in independent claim 9, a method of fabricating a display device includes:
placing a second substrate on a first substrate on which an active element layer is disposed; forming a dummy fusion pattern and a hole fusion pattern by fusing the first and second substrates to each other by irradiating a femtosecond laser beam onto at least one of the first and second substrates, the dummy fusion pattern being disposed on a first closed curve, and the hole fusion pattern being disposed on a second closed curve that is spaced apart from the first closed curve and outside the first closed curve; and forming a through hole penetrating the first substrate and the second substrate in a thickness direction by cutting the first substrate and the second substrate between the dummy fusion pattern and the hole fusion pattern.

In an example embodiment, the hole fusion pattern may be continuously formed without being disconnected, and the dummy fusion pattern may be formed into a plurality of parts by being at least partially disconnected.

In an example embodiment, the forming of the dummy fusion pattern and the hole fusion pattern may include: forming a sub-hole fusion pattern on a third closed curve that is spaced apart from the second closed curve and outside the second closed curve.

In an example embodiment, the forming of the through hole may include irradiating a cutting laser beam to at least one of the first and second substrates, and a wavelength of the cutting laser beam may be greater than a wavelength of the femtosecond laser beam.

In an example embodiment, each of the first substrate and the second substrate may include glass, and the dummy fusion pattern and the hole fusion pattern may be formed by fusing the first and second substrates to each other.

According to one or more example embodiments of the present disclosure, a display device may be provided in which a non-display area around (e.g., near or adjacent to) an optical hole may be reduced or minimized, and a method of fabricating the display device.

At least some of the above and other features of the invention are set out in the claims.

The aspects and features of the present disclosure are not limited to the aforementioned aspects and features, and various other aspects and features may be included in the present specification.

### BRIEF DESCRIPTION OF THE DRAWINGS

The above and other aspects and features of the present disclosure will become more apparent to those skilled in the art from the following detailed description of the example embodiments with reference to the accompanying drawings, in which:
FIG. 1 is a plan view of a display device according to an embodiment;
FIG. 2 is a cross-sectional view taken along the line II-II' of FIG. 1;
FIG. 3 is a layout view showing a planar arrangement relationship between members around a plurality of hole areas;
FIG. 4 is a cross-sectional view of a portion around a hole area of a display device according to an embodiment
FIG. 5 is a plan view of a display panel of a display device according to an embodiment;
FIG. 6 is a cross-sectional view taken along the lines A-A' and B-B' of FIG. 5;
FIG. 7 is a circuit diagram of a pixel of a display device according to an embodiment;
FIG. 8 is an enlarged view of the area C of FIG. 6;
FIGS. 9 and 10 are cross-sectional views for illustrating a method of fabricating a display device according to an embodiment;
FIG. 11 is a plan view of a portion around a hole area for illustrating a method of fabricating a display device according to an embodiment;
FIG. 12 is a cross-sectional view for illustrating a method of fabricating a display device according to an embodiment;
FIG. 13 is a plan view of a portion around a hole area for illustrating a method of fabricating a display device according to an embodiment;
FIG. 14 is a cross-sectional view of a display device according to another embodiment;
FIG. 15 is an enlarged plan view of a portion around a hole area of a display device according to another embodiment;
FIG. 16 is a cross-sectional view taken along the line XVI-XVI' of FIG. 15;
FIG. 17 is a cross-sectional view for illustrating a method of fabricating a display device according to another embodiment;
FIG. 18 is an enlarged plan view of a portion around a hole area;
FIG. 19 is a cross-sectional view for illustrating a method of fabricating a display device according to another embodiment; and
FIG. 20 is a plan view for illustrating a method of fabricating a display device according to another embodiment.

### DETAILED DESCRIPTION

Hereinafter, example embodiments will be described in more detail with reference to the accompanying drawings, in which like reference numbers refer to like elements throughout. The present disclosure, however, may be embodied in various different forms, and should not be construed as being limited to only the illustrated embodiments herein. Rather, these embodiments are provided as examples so that this disclosure will be thorough and complete, and will fully convey the aspects and features of the present disclosure to those skilled in the art. Accordingly, processes, elements, and techniques that are not necessary to those having ordinary skill in the art for a complete understanding of the aspects and features of the present disclosure may not be described. Unless otherwise noted, like reference numerals denote like elements throughout the attached drawings and the written description, and thus, descriptions thereof may not be repeated.

In the drawings, the relative sizes of elements, layers, and regions may be exaggerated and/or simplified for clarity. Spatially relative terms, such as "beneath," "below," "lower," "under," "above," "upper," and the like, may be used herein for ease of explanation to describe one element or feature's relationship to another element(s) or feature(s) as illustrated in the figures. It will be understood that the spatially relative terms are intended to encompass different orientations of the device in use or in operation, in addition to the orientation depicted in the figures. For example, if the device in the figures is turned over, elements described as "below" or "beneath" or "under" other elements or features would then be oriented "above" the other elements or features. Thus, the example terms "below" and "under" can encompass both an orientation of above and below. The device may be otherwise oriented (e.g., rotated 90 degrees or at other orientations) and the spatially relative descriptors used herein should be interpreted accordingly.

It will be understood that, although the terms "first," "second," "third," etc., may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described below could be termed a second element, component, region, layer or section, without departing from the scope of the present disclosure. Further, the description of an element such as a "first" element may not require or imply the presence of a second element or other elements. The terms "first", "second", and the like may also be used herein to differentiate different categories or sets of elements. For example, the terms "first", "second", and the like may represent a "first-category (or first-set)", a "second-category (or second-set)", and the like, respectively.

It will be understood that when an element or layer is referred to as being "on," "connected to," or "coupled to" another element or layer, it can be directly on, connected to, or coupled to the other element or layer, or one or more intervening elements or layers may be present. In addition, it will also be understood that when an element or layer is referred to as being "between" two elements or layers, it can be the only element or layer between the two elements or layers, or one or more intervening elements or layers may also be present.

The terminology used herein is for the purpose of describing particular embodiments and is not intended to be limiting of the present disclosure. As used herein, the singular forms "a" and "an" are intended to include the plural forms as well, unless the context clearly indicates otherwise. It will be further understood that the terms "comprises," "comprising," "includes," and "including," "has, " "have, " and "having," when used in this specification, specify the presence of the stated features, integers, steps, operations, elements, and/or components, but do not preclude the presence or addition of one or more other features, integers, steps, operations, elements, components, and/or groups thereof. As used herein, the term "and/or" includes any and all combinations of one or more of the associated listed items. Expressions such as "at least one of," when preceding a list of elements, modify the entire list of elements and do not modify the individual elements of the list.

As used herein, the term "substantially," "about," and similar terms are used as terms of approximation and not as terms of degree, and are intended to account for the inherent variations in measured or calculated values that would be recognized by those of ordinary skill in the art. Further, the use of "may" when describing embodiments of the present disclosure refers to "one or more embodiments of the present disclosure." As used herein, the terms "use," "using," and "used" may be considered synonymous with the terms "utilize," "utilizing," and "utilized," respectively.

Unless otherwise defined, all terms (including technical and scientific terms) used herein have the same meaning as commonly understood by one of ordinary skill in the art to which the present disclosure belongs. It will be further understood that terms, such as those defined in commonly used dictionaries, should be interpreted as having a meaning that is consistent with their meaning in the context of the relevant art and/or the present specification, and should not be interpreted in an idealized or overly formal sense, unless expressly so defined herein.

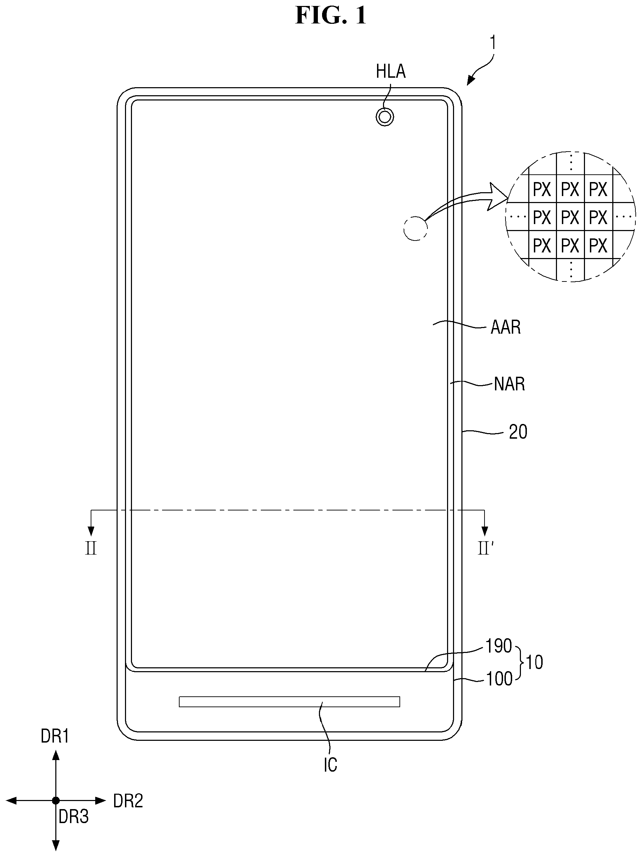

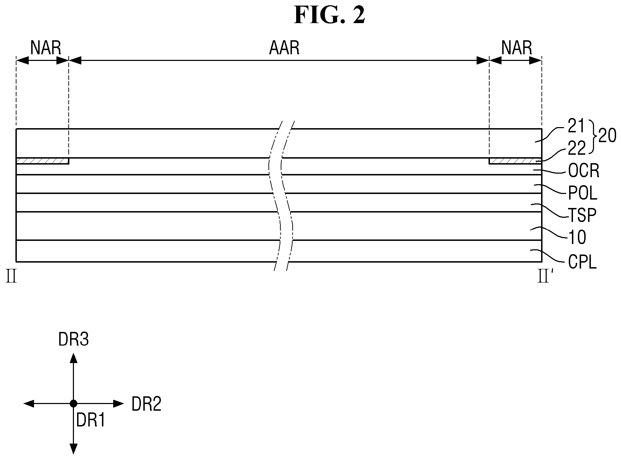

FIG. 1 is a plan view of a display device according to an embodiment. FIG. 2 is a cross-sectional view taken along the line II-II' of FIG. 1. For example, FIG. 2 is a schematic cross-sectional view of a display device according to an embodiment.

As used herein, a first direction DR1 and a second direction DR2 represent different directions that cross each other, for example, directions that cross each other at a right angle in a plan view. A third direction DR3 indicates a direction intersecting the plane on which the first direction DR1 and the second direction DR2 are located, and for example, may indicate a direction that perpendicularly intersects both the first direction DR1 and the second direction DR2. As shown in the figures, for example, the first direction DR1 may indicate a vertical direction of a display device 1, the second direction DR2 may indicate a horizontal direction of the display device 1, and the third direction DR3 may indicate a thickness direction of the display device 1.

As used herein, one side of the first direction DR1 refers to an upward direction in a plan view, and the other side of the first direction DR1 refers to a downward direction in the plan view. One side of the second direction DR2 refers to a rightward direction in a plan view, and the other side of the second direction DR2 refers to a leftward direction in the plan view. One side of the third direction DR3 refers to an upward direction in a cross-sectional view, and the other side of the third direction DR3 refers to a downward direction in the cross-sectional view. In addition, unless otherwise defined, with respect to the third direction DR3, the terms "above," "top surface," and "upper side" as used herein refer to a display surface's side of a display panel 10, and the terms "below," "bottom surface," and "lower side" as used herein refer to a side opposite to the display surface of the display panel 10. It should be understood, however, that the directions described in the present disclosure refer to relative directions, and thus, the present disclosure is not limited to the described directions.

Referring to FIGS. 1 and 2, a display device 1 displays a moving image and/or a still image. A main screen display direction may correspond to one side of the third direction DR3 (e.g., a top emission type display device), but the present disclosure is not limited thereto.

The display device 1 may refer to any suitable electronic device for providing a display screen. Examples of the display device 1 may include a television, a laptop computer, a monitor, a billboard, an Internet-of-Things device, and the like, as well as various suitable portable electronic devices, for example, such as a mobile phone, a smartphone, a tablet personal computer (PC), an electronic watch, a smart watch, a watch phone, a mobile communication terminal, an electronic notebook, an electronic book, a portable multimedia player (PMP), a navigation device, a game machine, a digital camera, and the like, which provide a display screen.

The display device 1 includes an active region AAR and a non-active region NAR. In the display device 1, an area where a screen is displayed is defined as a display area, and an area where a screen is not displayed is defined as a non-display area, and thus, the display area may be included at (e.g., in or on) the active region AAR and the non-display area may be included at (e.g., in or on) the non-active region NAR. When the display device 1 has a touch function, a touch area, which is an area where a touch input is sensed, may also be included at (e.g., in or on) the active region AAR. The display area and the touch area may overlap with each other. The active region AAR may be a region where the screen is displayed and the touch input is detected.

The active region AAR may include a plurality of pixels PX. The plurality of pixels PX may be arranged in a matrix. Each pixel PX may have a rectangular shape or a square shape in a plan view (e.g., when viewed from above), but the present disclosure is not limited thereto.

The non-active region NAR is disposed around (e.g., near or adjacent to) the active region AAR. For example, the non-active region NAR may at least partially surround (e.g., around a periphery of) the active region AAR. The non-active region NAR may be a bezel area. The non-active region NAR may overlap with a printed layer (e.g., see 22 in FIG. 2) of a window member (e.g., see 20 in FIG. 2), which will be described in more detail below.

The non-active region NAR may surround (e.g., around a periphery of) all sides (e.g., four sides as shown in FIG. 1) of the active region AAR. However, the present disclosure is not limited thereto. For example, the non-active region NAR may not be disposed near (e.g., adjacent to) at least one of the four sides of the active region AAR.

At (e.g., in or on) the non-active region NAR, signal lines and/or driving circuits may be disposed for applying a signal to the active region AAR (e.g., to a display area and/or to a touch area). In an embodiment, a driving chip IC may be disposed at (e.g., in or on) the non-active region NAR. The driving chip IC may include an integrated circuit for driving the display panel 10. The integrated circuit may include an integrated circuit for a display and/or an integrated circuit for a touch member (TSP). The driving chip IC may be directly mounted on a region where a first substrate 100 protrudes with respect to a second substrate 190.

The display device 1 may further include a hole area HLA including at least one hole HLE in the active region AAR. The hole area HLA will be described in more detail below.

FIG. 2 is a cross-sectional view taken along the line II-II' of FIG. 1. Hereinafter, a cross-sectional structure of the display device 1 will be described with reference to FIGS. 1 and 2.

The display device 1 includes a display panel 10 that provides a display screen, a touch member TSP, a polarizing member POL, a window member 20, and a cover panel CPL. The cover panel CPL may be disposed below the display panel 10.

The display panel 10 may provide a display screen. In other words, the display panel 10 may provide a video and/or an image. Examples of the display panel 10 may include an organic light emitting display panel, a micro LED display panel, a nano LED display panel, a quantum dot light emitting display panel, a liquid crystal display panel, a plasma display panel, a field emission display panel, an electrophoretic display panel, an electrowetting display panel, and the like. In the following description, a case where an organic light emitting display panel is applied as an example of the display panel 10 will be described in more detail for convenience, but the present disclosure is not limited thereto, and other suitable display panels may be applied as the display panel 10. The display panel 10 will be described in more detail below.

The touch member TSP may be disposed on the display panel 10. The touch member TSP may sense a touch input. The touch member TSP may be disposed on a top surface (e.g., one surface) of the second substrate 190. The touch member TSP may be provided integrally with the display panel 10 in the form of a touch layer as illustrated in the following embodiment. However, the present disclosure is not limited thereto, and the touch member TSP may be disposed on the display panel 10 in the form of a touch panel or a touch film. The touch member TSP may include a plurality of touch electrodes. However, the present disclosure is not limited thereto, and in other embodiments, the touch member TSP may be omitted.

The polarizing member POL polarizes light passing therethrough. The polarizing member POL may serve to reduce the reflection of external light. The polarizing member POL may be attached onto the touch member TSP through a polarization bonding layer (not shown). When the touch member TSP is omitted, the polarizing member POL may be attached onto the second substrate 190.

The window member 20 is disposed on the polarizing member POL. The window member 20 serves to cover and protect the display panel 10. The window member 20 may include a window substrate 21, and a printed layer 22 disposed on the window substrate 21. The window member 20 may be attached onto one surface of the display panel 10 through a transparent bonding layer OCR including an optical clear adhesive (OCA), an optical clear resin (OCR), and/or the like. When the display device 1 includes the polarizing member POL, the window member 20 may be attached onto a top surface (e.g., one surface) of the polarizing member POL.

The window substrate 21 may be made of a transparent material. The window substrate 21 may be made of, for example, glass or plastic.

The planar shape of the window substrate 21 corresponds to the shape of the display device 1 to which it is applied. For example, when the display device 1 has a rectangular shape or a substantially rectangular shape in a plan view, the window substrate 21 may also have a rectangular shape or a substantially rectangular shape in the plan view. As another example, when the display device 1 has a circular shape in a plan view, the window substrate 21 may also have a circular shape in the plan view.

The printed layer 22 may be disposed on the window substrate 21. The printed layer 22 may be disposed on one surface and/or another surface of the window substrate 21. The printed layer 22 may be disposed on an edge portion of the window substrate 21, and may be disposed on the non-active region NAR. In addition, the printed layer 22 may also be disposed within the hole area HLA. The printed layer 22 may be a light blocking layer or a decorative layer for providing an aesthetic appeal.

Hereinafter, the hole area HLA of the display device 1 will be described in more detail.

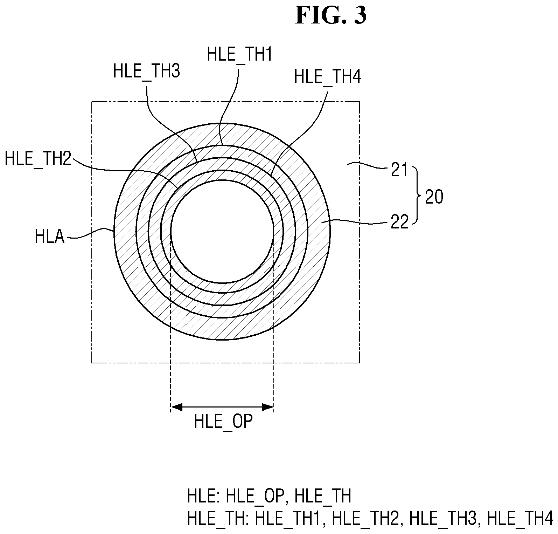

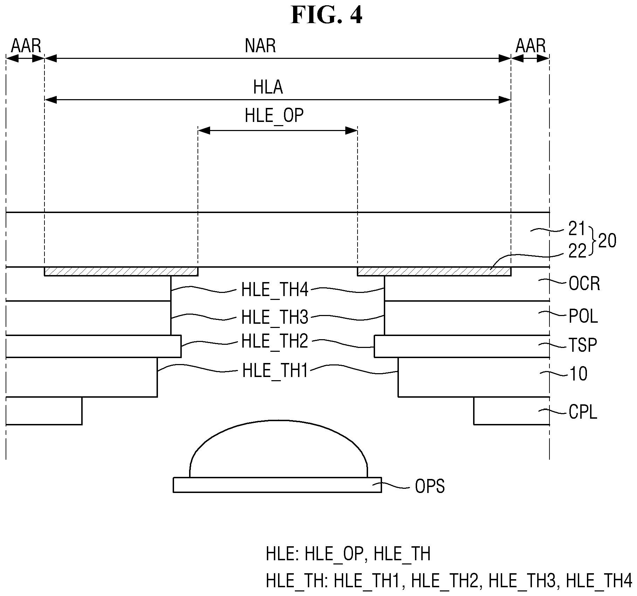

FIG. 3 is a layout view showing a planar arrangement relationship between members around a plurality of hole areas. FIG. 4 is a cross-sectional view of a portion around a hole area of a display device according to an embodiment.

Referring to FIGS. 1 to 4, the hole area HLA may be biased to one side of the first direction DR1 of the display device 1. The hole area HLA itself may be (e.g., may be included as part of) the non-active region NAR where display and/or touch is not performed. The hole area HLA may be disposed within the active region AAR. In other words, the hole area HLA may be surrounded (e.g., around a periphery thereof) by the active region AAR as shown in FIG. 1. In another example, the hole area HLA may be disposed to be surrounded (e.g., around a periphery thereof) by the non-active region NAR, or may be disposed near (e.g., adjacent to) or at (e.g., in or on) a boundary between the active region AAR and the non-active region NAR so that a part of the hole area HLA is surrounded (e.g., around a periphery thereof) by the active region AAR, and another part of the hole area HLA is surrounded (e.g., around a periphery thereof) by the non-active region NAR.

The hole area HLA may have a suitable shape in a plan view, for example, such as a circle, an ellipse, a dumbbell, a rectangle with convex short sides, and/or the like. However, the present disclosure is not limited thereto, and the planar shape of the hole area HLA may be variously modified, for example, such as to a rectangle, a square, and/or other polygons.

The hole area HLA may include at least one hole HLE. The shape of the hole HLE in a plan view may correspond to the shape of the hole area HLA in the plan view. However, the present disclosure is not limited thereto, and the hole HLA may have any suitable shape in the plan view, for example, such as a circular shape, an elliptical shape, or the like.

The hole HLE may include a physical through hole HLE_TH. The through hole HLE_TH may have a circular shape in a plan view, although the present disclosure is not limited thereto. The through hole HLE_TH may include a first through hole HLE_TH1 that physically penetrates the display panel 10, a second through hole HLE_TH2 that physically penetrates the touch member TSP, a third hole HLE_TH3 that physically penetrates the polarizing member POL, and a fourth through hole HLE_TH4 that physically penetrates the transparent bonding layer OCR. By removing portions of the above-described members (e.g., by removing portions of the display panel 10, the touch member TSP, the polarizing member POL, and the transparent bonding layer OCR) from the through hole HLE_TH, light transmittance in the corresponding region may be improved.

The first through hole HLE_TH1, the second through hole HLE_TH2, the third through hole HLE_TH3, and the fourth through hole HLE_TH4 may overlap with each other at (e.g., in or on) at least a partial region. Accordingly, it may be possible to ensure an optical path through which external light enters an optical element OPS.

The hole HLE may further include an optical hole HLE_OP, which is an optical light transmitting window, in addition to the through hole HLE_TH. The optical hole HLE_OP may be disposed in the hole area HLA. The optical hole HLE_OP may overlap with the through hole HLE_TH, and may be defined by a pattern of the printed layer 22 of the window member 20. The printed layer 22 may be disposed partially in the hole area HLA to prevent or substantially prevent light of the pixel PX from being emitted through the through hole HLE_TH (e.g., to prevent or substantially prevent a light leakage phenomenon). The printed layer 22 may be disposed to extend up to the outer periphery of the hole area HLA, but the present disclosure is not limited thereto.

The printed layer 22 is disposed around (e.g., to surround around a periphery of) the through hole HLE_TH, and exposes at least a part of the through hole HLE_TH. The area of the through hole HLE_TH that is exposed by the printed layer 22 may correspond to (e.g., may be or may define) the optical hole HLE_OP through which light passes. In one embodiment, the printed layer 22 at (e.g., in or on) the hole area HLA may partially overlap with the through hole HLE_TH. In other words, an inner surface of the printed layer 22 may protrude further inward from an inner wall of the through hole HLE_TH. The inner surface of the printed layer 22 may be aligned with an inner wall of the through hole HLE_TH having a minimum radius, or may be disposed closer to the inside thereof (e.g., may be disposed to protrude further inward than the inner wall defining the minimum radius of the through hole HLE_TH). Accordingly, the inner walls of the first through hole HLE_TH1, the second through hole HLE_TH2, the third through hole HLE_TH3, and the fourth through hole HLE_TH4 below the printed layer 22 may be covered by the printed layer 22, and thus, may not be visually recognized from the outside.

The display device 1 may further include the optical element OPS including a light receiving portion. Examples of the optical element OPS including the light receiving portion may include a camera, a lens (e.g., a condenser lens or an optical path guide lens), and an optical sensor, for example, such as an infrared sensor, an iris recognition sensor, an illuminance sensor, and/or the like. The optical element OPS may be disposed to overlap with the hole area HLA on the other surface side of the display panel 10. At least a part of the light receiving portion of the optical element OPS may be disposed in the optical hole HLE_OP. Light from the outside of the display device 1 may pass through the window substrate 21 surrounded by the printed layer 22, and may enter the light receiving portion. As described above, when the window substrate 21 exhibits high transmittance, external light may reach the light receiving portion of the optical element OPS through the optical path without a large loss.

The display device 1 may further include the cover panel CPL. The cover panel CPL may be disposed on the other surface of the first substrate 100. The cover panel CPL may include a heat dissipation layer, a cushion layer, and/or the like. The cover panel CPL may not be disposed at least in a region overlapping with at least one of the optical hole HLE_OP or the through hole HLE_TH.

Hereinafter, the display panel 10 of the display device 1 will be described in more detail.

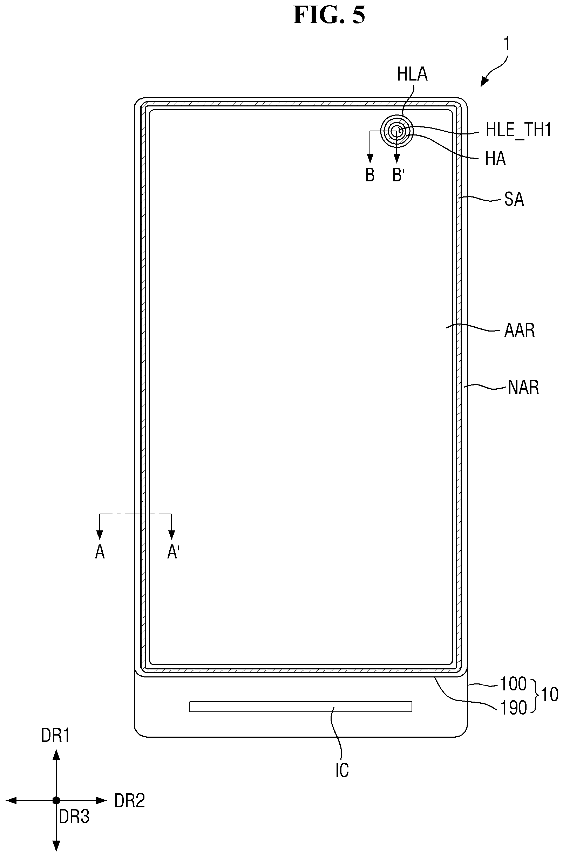

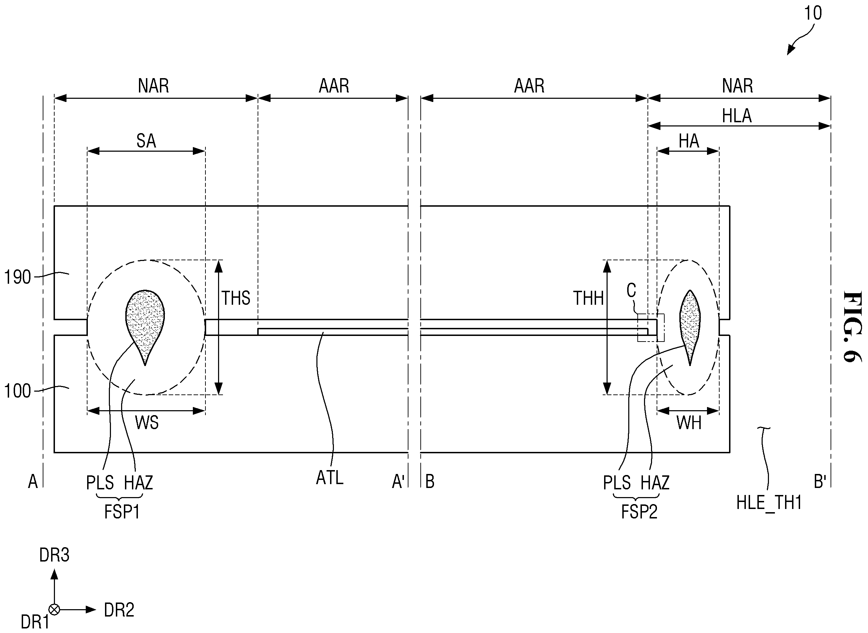

FIG. 5 is a plan view of a display panel of a display device according to an embodiment. FIG. 6 is a cross-sectional view taken along the lines A-A' and B-B' of FIG. 5.

Referring to FIGS. 5 and 6, the display panel 10 may include a first substrate 100, a second substrate 190, an active element layer ATL, a substrate encapsulation area SA, and a hole encapsulation area HA.

The first substrate 100 may support the active element layer ATL disposed thereon. The first substrate 100 may be generally transparent, and may have high light transmittance. The first substrate 100 may include an inorganic material, for example, such as glass according to the claimed invention, and/or quartz, but the present disclosure is not limited thereto. The inorganic material may include, for example, silicon oxide (SiO₂), but the present disclosure is not limited thereto. However, without being limited thereto, the first substrate 100 may be a transparent plate or a transparent film.

The second substrate 190 may be disposed to face the first substrate 100 while being spaced apart from the first substrate 100. The second substrate 190 may protect the active element layer ATL from external moisture, air, and/or the like. The second substrate 190 may be generally transparent, and may have high light transmittance. The second substrate 190 may include an inorganic material, for example, such as glass according to the claimed invention, quartz, and/or the like, but the present disclosure is not limited thereto. The inorganic material may include, for example, silicon oxide (SiO₂), but the present disclosure is not limited thereto. However, without being limited thereto, the second substrate 190 may be a transparent plate or a transparent film.

The active element layer ATL may be disposed between the first substrate 100 and the second substrate 190. The active element layer ATL may be disposed on the top surface (e.g., one surface) of the first substrate 100. The active element layer ATL may cover most areas of the first substrate 100, except a partial area of the first substrate 100. In other words, the active element layer ATL may not overlap with the first through hole HLE_TH1 in the thickness direction (e.g., the third direction DR3), and may not be disposed at (e.g., in or on) a region where the first through hole HLE_TH1 is formed. Further, the active element layer ATL may not be disposed at (e.g., in or on) at least a partial region of the non-active region NAR. The active element layer ATL may include a light emitting element, and a thin film transistor for driving the light emitting element. The active element layer ATL may be spaced apart from the second substrate 190 disposed above the active element layer ATL, but the present disclosure is not limited thereto. The active element layer ATL will be described in more detail below.

The first substrate 100 and the second substrate 190 of the display panel 10 may have an area where there is no physical interface between the first substrate 100 and the second substrate 190. As used herein, the phrase "there is no or substantially no physical boundary between both components" means that there is no physical interface that can physically partition both components.

The display device 1 according to the claimed invention further includes an edge fusion pattern FSP1 and a hole fusion pattern FSP2 in which there is no or substantially no physical boundary between the first substrate 100 and the second substrate 190 of the display panel 10. The edge fusion pattern FSP1 and the hole fusion pattern FSP2 are formed by fusing the first substrate 100 and the second substrate 190 to each other. The first substrate 100 and the second substrate 190 are bonded to each other by the edge fusion pattern FSP1 and the hole fusion pattern FSP2. The edge fusion pattern FSP1 may be disposed at (e.g., in or on) the substrate encapsulation area SA, and the hole fusion pattern FSP2 may be disposed at (e.g., in or on) the hole encapsulation area HA. In other words, the first substrate 100 and the second substrate 190 may be fused and bonded to each other at (e.g., in or on) the substrate encapsulation area SA and at (e.g., in or on) the hole encapsulation area HA.

The edge fusion pattern FSP1 and the hole fusion pattern FSP2 may be formed across the first substrate 100 and the second substrate 190. As used herein, the phrase "being formed across components or being disposed across components" means that the components are connected through a space provided by the components. In other words, the edge fusion pattern FSP1 and the hole fusion pattern FSP2 may be formed integrally from the first substrate 100 to the second substrate 190 without being disconnected.

The edge fusion pattern FSP1 and the hole fusion pattern FSP2 may be spaced apart from the active element layer ATL by a suitable distance (e.g., a predetermined distance) without overlapping with the active element layer ATL. The distance between the edge fusion pattern FSP1 and the active element layer ATL may be greater than the distance between the hole fusion pattern FSP2 and the active element layer ATL. However, the present disclosure is not limited thereto.

The edge fusion pattern FSP1 may be spaced apart from an outer wall (e.g., an outer edge surface) of the display panel 10 by a suitable distance (e.g., a predetermined distance). The first substrate 100 and the second substrate 190 may be spaced apart from each other by a suitable distance (e.g., a predetermined distance) in the thickness direction (e.g., the third direction DR3) between the edge fusion pattern FSP1 and the outer wall of the display panel 10 that are spaced apart from each other. Therefore, an edge of the display panel 10 may have a curved shape in which an outer surface of the first substrate 100, an outer surface of the second substrate 190, and an outer side of the edge fusion pattern FSP1 are connected to each other in a cross-sectional view.

The hole fusion pattern FSP2 may be spaced apart from an inner wall of the first through hole HLE_TH1 by a suitable distance (e.g., a predetermined distance).

The first substrate 100 and the second substrate 190 may be spaced apart from each other by a suitable distance (e.g., a predetermined distance) in the thickness direction (e.g., the third direction DR3) between the hole fusion pattern FSP2 and the inner wall of the first through hole HLE_TH1 that are spaced apart from each other. Therefore, the inner wall of the first through hole HLE_TH1 may have a curved shape in which an inner surface of the first substrate 100, an inner surface of the second substrate 190, and an inner side of the hole fusion pattern FSP2 are connected to each other in a cross-sectional view.

Each of the edge fusion pattern FSP1 and the hole fusion pattern FSP2 may include a central portion PLS and a peripheral portion HAZ.

The central portion PLS may include a plasma structure. The central portion PLS may be formed in a shape having a long axis and a short axis crossing each other. The plasma structure may have various suitable sizes. However, the present disclosure is not limited thereto, and the plasma structure may not exist or may not be visually recognized even though it exists.

The peripheral portion HAZ may coincide with or substantially coincide with a region where heat is diffused due to influence of thermal energy generated by laser irradiation, which will be described in more detail below. The peripheral portion HAZ may be a region formed by partially melting each of the first substrate 100 and the second substrate 190 by heat, and then solidifying the melted portions. The sizes of the edge fusion pattern FSP1 and the hole fusion pattern FSP2 may be the same or substantially the same as those of the peripheral portions HAZ thereof. In other words, the size of the edge fusion pattern FSP1 may be the same or substantially the same as that of the peripheral portion HAZ of the edge fusion pattern FSP1, and the size of the hole fusion pattern FSP2 may be the same or substantially the same as that of the peripheral portion HAZ of the hole fusion pattern FSP2.

The central portion PLS and the peripheral portion HAZ may be melted at different temperatures from each other, and then solidified. Accordingly, the central portion PLS and the peripheral portion HAZ may have different refractive indices from each other. As a result, the central portion PLS and the peripheral portion HAZ may be visually recognized in a plan view. In other words, the central portion PLS and the peripheral portion HAZ may have different optical characteristics due to a difference in processing temperatures, so that the central portion PLS and the peripheral portion HAZ may be visually distinguished from each other. Therefore, the first substrate 100, the second substrate 190, the central portion PLS, and the peripheral portion HAZ may be visually distinguished from each other. The peripheral portion HAZ may be formed to surround (e.g., around a periphery of) the central portion PLS, but the present disclosure is not limited thereto.

A width WH of the hole fusion pattern FSP2 may be smaller than a width WS of the edge fusion pattern FSP1. For example, the width WH of the hole fusion pattern FSP2 may be within a range that is greater than or equal to 1/5 and less than or equal to 1/2 of the width WS of the edge fusion pattern FSP1, but the present disclosure is not limited thereto. In a non-limiting example, the width WH of the hole fusion pattern FSP2 may be 100 µm or less, or 150 µm or less. Because the width WH of the hole fusion pattern FSP2 is smaller than the width WS of the edge fusion pattern FSP1, the non-active region NAR (e.g., the hole area HLA) around (e.g., adjacent to) the through hole HLE_TH may be further reduced, which may provide a more immersive display screen to a user.

The width WS of the edge fusion pattern FSP1 indicates a width in a traveling direction (e.g., an extending direction) of the edge fusion pattern FSP1, and a direction perpendicular to the thickness direction (e.g., the third direction DR3) in a plan view. In other words, the width WS of the edge fusion pattern FSP1 at a portion extended in the first direction DR1 in a plan view indicates a width in the second direction DR2, and the width WS of the edge fusion pattern FSP1 at a portion extended in the second direction DR2 in the plan view indicates a width in the first direction DR1. In FIG. 6, the width of the edge fusion pattern FSP1 is shown in the second direction DR2 as an example.

The width WH of the hole fusion pattern FSP2 indicates a width in a traveling direction (e.g., an extending direction) of the hole fusion pattern FSP2, and a width in a direction perpendicular to the thickness direction (e.g., the third direction DR3) in a plan view. In other words, the width WH of the hole fusion pattern FSP2 disposed in a circular shape in a plan view indicates a shortest distance between the inside and the outside of the hole fusion pattern FSP2 with respect to the direction perpendicular to the thickness direction (e.g., the third direction DR3). The inside of the hole fusion pattern FSP2 may indicate the first through hole HLE_TH1 side, and the outside of the hole fusion pattern FSP2 may indicate an opposite side of the first through hole HLE_TH1. For example, the width of the hole fusion pattern FSP2 is shown in the second direction DR2 in FIG. 6, but the present disclosure is not limited thereto.

An aspect ratio of the hole fusion pattern FSP2 may be higher than that of the edge fusion pattern FSP1. For example, the aspect ratio of the hole fusion pattern FSP2 may be higher than that of the edge fusion pattern FSP1 by 1.5 times or more, or by 3 times or more, but the present disclosure is not limited thereto. The aspect ratio of the edge fusion pattern FSP1 indicates a ratio between a thickness THS and the width WS of the edge fusion pattern FSP1, and the aspect ratio of the hole fusion pattern FSP2 indicates a ratio between a thickness THH and the width WH of the hole fusion pattern FSP2. The aspect ratio of the hole fusion pattern FSP2 may be, for example, higher than 1.56:1, higher than 1.9:1, or higher than 2.5:1, but the present disclosure is not limited thereto. In other words, the thickness THH of the hole fusion pattern FSP2 may be greater than the width WH of the hole fusion pattern FSP2 by 1.56 times or more, 1.9 times or more, or 2.5 times or more, but the present disclosure is not limited thereto. Due to the high aspect ratio of the hole fusion pattern FSP2, the hole fusion pattern FSP2 may have the thickness THH that is suitable to fuse the first substrate 100 and the second substrate 190 to each other, and the width WH of the hole fusion pattern FSP2 may be reduced.

The first substrate 100 and the second substrate 190 may be encapsulated by the edge fusion pattern FSP1 and the hole fusion pattern FSP2 at (e.g., in or on) the substrate encapsulation area SA and the hole encapsulation area HA, respectively.

In more detail, the substrate encapsulation area SA may be disposed at (e.g., in or on) the non-active region NAR, and may be disposed along the edges of the display panel 10. The substrate encapsulation area SA may be disposed in a closed shape in a plan view. Although it is illustrated in FIG. 5 that the substrate encapsulation area SA has a frame shape having a hollow portion, the present disclosure is not limited thereto.

The edge fusion pattern FSP1 may be disposed in the substrate encapsulation area SA. In the substrate encapsulation area SA, the first substrate 100 and the second substrate 190 may be bonded to each other by the edge fusion pattern FSP1. The shape of the edge fusion pattern FSP1 in a plan view may correspond to that of the substrate encapsulation area SA in the plan view, but the present disclosure is not limited thereto. In other words, the edge fusion pattern FSP1 may be disposed along the edges of the display panel 10. Accordingly, it may be possible to prevent or substantially prevent permeation of external air, moisture, and/or the like into the inner region from the outside of the display panel 10 through a side surface of the display panel 10. In other words, the edge fusion pattern FSP1 may encapsulate the display panel 10 from four side surfaces of the display panel 10.

The hole encapsulation area HA may be disposed at (e.g., in or on) the hole area HLA, and may be disposed along an edge of the first through hole HLE_TH1. The hole encapsulation area HA may be disposed in a closed shape. In other words, the hole encapsulation area HA may be disposed to completely surround (e.g., around a periphery of) the first through hole HLE_TH1. For example, the hole encapsulation area HA may have a donut shape, but the present disclosure is not limited thereto.

The hole fusion pattern FSP2 may be disposed in the hole encapsulation area HA. In the hole encapsulation area HA, the first substrate 100 and the second substrate 190 may be bonded to each other by the hole fusion pattern FSP2. For example, the shape of the hole fusion pattern FSP2 in a plan view may correspond to that of the hole encapsulation area HA in the plan view, but the present disclosure is not limited thereto. In other words, the hole fusion pattern FSP2 may be disposed along the edge of the first through hole HLE_TH1. Accordingly, it may be possible to prevent or substantially prevent permeation of external air, moisture, and/or the like into the inner region from the inside of the first through hole HLE_TH1. In other words, the hole fusion pattern FSP2 may encapsulate the display panel 10 from the inner surfaces of the through hole HLE_TH.

Therefore, the edge fusion pattern FSP1 and the hole fusion pattern FSP2 may be disposed to surround an inner space of the first substrate 100 and the second substrate 190 that are spaced apart from each other in the thickness direction (e.g., the third direction DR3), and may seal the inner space. An inner region of the display panel 10 defined by the first substrate 100 and the second substrate 190 may be in a vacuum state. However, the present disclosure is not limited thereto, and the inner region may be filled with gas or a filler. The gas may include, for example, inert gas, normal atmosphere, or the like, but the present disclosure is not limited thereto.

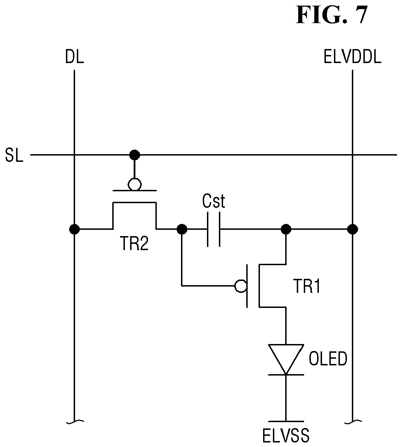

FIG. 7 is a circuit diagram of a pixel of a display device according to an embodiment.

Referring to FIG. 7, a circuit of the pixel PX may include a first transistor TR1, a second transistor TR2, a capacitor Cst, and an organic light emitting diode OLED. The circuit of each pixel PX is connected to a corresponding scan line SL, a corresponding data line DL, and a first source voltage line ELVDDL.

The first transistor TR1 may be a driving transistor and the second transistor TR2 may be a switching transistor. Although it is illustrated in FIG. 7 that both the first transistor TR1 and the second transistor TR2 are PMOS transistors, the present disclosure is not limited thereto, and any one of or both of the first transistor TR1 and the second transistor TR2 may be an NMOS transistor(s) as needed or desired.

A first electrode (e.g., a source electrode) of the first transistor TR1 is connected to the first source voltage line ELVDDL, and a second electrode (e.g., a drain electrode) of the first transistor TR1 is connected to an anode electrode of the organic light emitting diode OLED. A first electrode (e.g., a source electrode) of the second transistor TR2 is connected to the data line DL, and a second electrode (e.g., a drain electrode) of the second transistor TR2 is connected to a gate electrode of the first transistor TR1. The capacitor Cst is connected between the gate electrode and the first electrode of the first transistor TR1. The cathode electrode of the organic light emitting diode OLED receives a second source voltage ELVSS. The second source voltage ELVSS may be lower than a first source voltage ELVDD provided from the first source voltage line ELVDDL.

The second transistor TR2 may output a data signal applied to the data line DL in response to a scan signal applied to the scan line SL. The capacitor Cst may charge a voltage corresponding to the data signal received from the second transistor TR2. The first transistor TR1 may control a driving current flowing through the organic light emitting diode OLED in response to the amount of charges stored in the capacitor Cst.

An equivalent circuit of the pixel PX shown in FIG. 7 is merely one example embodiment, and thus, the present disclosure is not limited thereto. For example, in other embodiments, the pixel circuit of the pixel PX may include a larger number of transistors (e.g., three or seven) and/or capacitors, as needed or desired.

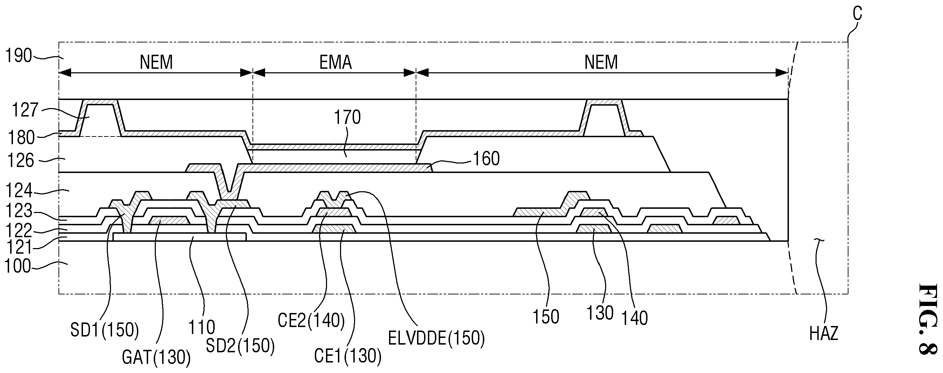

FIG. 8 is an enlarged view of the area C of FIG. 6. The active element layer ATL of the display panel 10 will be described in more detail with reference to FIG. 8.

Referring to FIGS. 6 and 8, the active element layer ATL may include at least one semiconductor layer 110, a plurality of conductive layers, and a plurality of insulating layers. The active element layer ATL may not be disposed at (e.g., in or on) the substrate encapsulation area SA and the hole encapsulation area HA. In other words, the active element layer ATL may be spaced apart from the edge fusion pattern FSP1 and the hole fusion pattern FSP2. The semiconductor layer 110, the plurality of conductive layers, and the plurality of insulating layers of the active element layer ATL may be spaced apart from the edge fusion pattern FSP1 and the hole fusion pattern FSP2. However, the present disclosure is not limited thereto, and in some embodiments, a part of the plurality of insulating layers may be disposed at (e.g., in or on) the substrate encapsulation area SA and/or the hole encapsulation area HA. In this case, the edge fusion pattern FSP1 and/or the hole fusion pattern FSP2 may be formed so as to penetrate the part of the plurality of insulating layers.

The active element layer ATL may include the semiconductor layer 110, a first insulating layer 121, a first gate conductive layer 130, a second insulating layer 122, a second gate conductive layer 140, a third insulating layer 123, a data conductive layer 150, a fourth insulating layer 124, an anode electrode 160, a bank layer 126 including an opening exposing the anode electrode 160, a light emitting layer 170 disposed in the opening of the bank layer 126, and a cathode electrode 180 disposed on the light emitting layer 170 and the bank layer 126. The above layers may be sequentially stacked in the above-described order. In addition, each of the above layers may include a single layer, or a stack of multiple layers. However, the present disclosure is not limited thereto, and other layers may be further disposed between the above layers.

The semiconductor layer 110 is disposed on the first substrate 100. The semiconductor layer 110 forms a channel of a thin film transistor of the pixel PX. The semiconductor layer 110 may include polycrystalline silicon. However, the present disclosure is not limited thereto, and the semiconductor layer 110 may include monocrystalline silicon, low-temperature polycrystalline silicon, amorphous silicon, or an oxide semiconductor. The oxide semiconductor may include, for example, a binary compound (ABx), a ternary compound (ABxCy), or a quaternary compound (ABxCyDz) including indium, zinc, gallium, tin, titanium, aluminium, hafnium (Hf), zirconium (Zr), magnesium (Mg), and/or the like.

The first insulating layer 121 is disposed on the semiconductor layer 110. The first insulating layer 121 may be a gate insulating layer having a gate insulating function. The first insulating layer 121 may include a silicon compound, a metal oxide, or the like. For example, the first insulating layer 121 may include silicon oxide, silicon nitride, silicon oxynitride, aluminium oxide, tantalum oxide, hafnium oxide, zirconium oxide, titanium oxide, or the like.

The first gate conductive layer 130 is disposed on the first insulating layer 121. The first gate conductive layer 130 may include a gate electrode GAT of the thin film transistor of the pixel PX, a scan line connected to the gate electrode GAT, and a first electrode CE1 of a storage capacitor.

The first gate conductive layer 130 may include at least one metal selected from the group consisting of molybdenum (Mo), aluminium (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), and copper (Cu).

The second insulating layer 122 may be disposed on the first gate conductive layer 130. The second insulating layer 122 may be an interlayer insulating layer or a second gate insulating layer. The second insulating layer 122 may include an inorganic insulating material, for example, such as silicon oxide, silicon nitride, silicon oxynitride, hafnium oxide, aluminium oxide, titanium oxide, tantalum oxide, zinc oxide, and/or the like.

The second gate conductive layer 140 is disposed on the second insulating layer 122. The second gate conductive layer 140 may include a second electrode CE2 of the storage capacitor. The second gate conductive layer 140 may include at least one metal selected from the group consisting of molybdenum (Mo), aluminium (Al), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), and copper (Cu). The second gate conductive layer 140 may be made of the same or substantially the same material as that of the first gate conductive layer 130, but the present disclosure is not limited thereto.

The third insulating layer 123 is disposed on the second gate conductive layer 140. The third insulating layer 123 may be an interlayer insulating layer. The third insulating layer 123 may include an inorganic insulating material, for example, such as silicon oxide, silicon nitride, silicon oxynitride, hafnium oxide, aluminium oxide, titanium oxide, tantalum oxide, zinc oxide, and/or the like.

The data conductive layer 150 is disposed on the third insulating layer 123. The data conductive layer 150 may include a first electrode SD1 and a second electrode SD2 of the thin film transistor of the pixel PX. The first electrode SD1 and the second electrode SD2 of the thin film transistor may be electrically connected to a source region and a drain region of the semiconductor layer 110 via contact holes passing through the third insulating layer 123, the second insulating layer 122, and the first insulating layer 121. The data conductive layer 150 may further include a first source voltage electrode ELVDDE of the pixel PX. The first source voltage electrode ELVDDE may be electrically connected to the second electrode CE2 of the storage capacitor through a contact hole penetrating the third insulating layer 123.

The data conductive layer 150 may include at least one metal selected from the group consisting of aluminium (Al), molybdenum (Mo), platinum (Pt), palladium (Pd), silver (Ag), magnesium (Mg), gold (Au), nickel (Ni), neodymium (Nd), iridium (Ir), chromium (Cr), calcium (Ca), titanium (Ti), tantalum (Ta), tungsten (W), and copper (Cu). The data conductive layer 150 may be a single layer or multilayers. For example, the data conductive layer 150 may have a stacked structure of Ti/Al/Ti, Mo/Al/Mo, Mo/AlGe/Mo, or Ti/Cu.

The fourth insulating layer 124 is disposed on the data conductive layer 150. The fourth insulating layer 124 covers the data conductive layer 150. The fourth insulating layer 124 may be a via layer. The fourth insulating layer 124 may include an organic insulating material.

The anode electrode 160 is disposed on the fourth insulating layer 124. The anode electrode 160 may be a pixel electrode provided for each pixel PX. The anode electrode 160 may be connected to the second electrode SD2 of the thin film transistor via a contact hole passing through the fourth insulating layer 124. The anode electrode 160 may at least partially overlap with an emission region EMA of the pixel PX.

The anode electrode 160 may have a stacked structure formed by stacking a material layer having a high work function, for example, such as indium tin oxide (ITO), indium zinc oxide (IZO), zinc oxide (ZnO), and/or indium oxide (In₂O₃), and a reflective material layer, for example, such as silver (Ag), magnesium (Mg), aluminium (Al), platinum (Pt), lead (Pb), gold (Au), nickel (Ni), neodymium (Nd), iridium (Ir), chromium (Cr), lithium (Li), calcium (Ca), or a mixture thereof. However, the present disclosure is not limited thereto. The layer having a high work function may be disposed above the reflective material layer, and may be disposed closer to the light emitting layer 170 than the reflective material layer. The anode electrode 160 may have a multilayered structure, for example, such as ITO/Mg, ITO/MgF, ITO/Ag, and/or ITO/Ag/ITO, but the present disclosure is not limited thereto.

The bank layer 126 may be disposed on the anode electrode 160. The bank layer 126 may be disposed on the anode electrode 160, and may include an opening exposing the anode electrode 160. The emission region EMA and a non-emission region NEM may be distinguished from each other by the bank layer 126 and the opening thereof. The bank layer 126 may include an organic insulating material, for example, such as acrylic resin, epoxy resin, phenolic resin, polyamide resin, polyimide resin, unsaturated polyester resin, polyphenylene resin, polyphenylenesulfide resin, or benzocyclobutene (BCB). In some embodiments, the bank layer 126 may also include an inorganic material.

The display device 1 may further include a spacer 127. The spacer 127 may be disposed on the bank layer 126. The spacer 127 may be disposed directly on the bank layer 126. The spacer 127 may overlap with the bank layer 126 in the thickness direction. The spacer 127 may serve to maintain a gap with a structure disposed thereabove. Also, the spacer 127 may serve to support a structure stacked thereon, and may serve to mitigate deformation caused by stress when the display panel 10 is pressed. For example, the spacer 127 may support the second substrate 190 disposed thereon, and may prevent or substantially prevent the second substrate 190 from slipping down (e.g., from moving, warping, or bending downwards). Further, in the case of depositing an organic material of the light emitting layer 170 through a fine metal mask FMM, the spacer 127 may serve to prevent or substantially prevent the fine metal mask FMM from slipping down (e.g., from moving, warping, or bending downwards). The spacer 127 may have a width smaller than that of the bank layer 126. The spacer 127 may be disposed on a part (e.g., a portion) of the bank layer 126, and thus, may cause a stepped portion with respect to a portion (e.g., of the bank layer 126) where the spacer 127 is not disposed.

The spacer 127 may include an organic insulating material, similarly to the bank layer 126. The spacer 127 and the bank layer 126 may be formed as separate layers from each other, or may be made of the same or substantially the same material and formed by the same or substantially the same process (e.g., formed by one process). For example, the bank layer 126 and the spacer 127 having different heights may be formed by the same process (e.g., may be formed by one process) by coating a photosensitive organic material, and then performing exposure and development using a slit mask or a halftone mask.

The light emitting layer 170 is disposed on the anode electrode 160 exposed by the bank layer 126. The light emitting layer 170 may include an organic material layer. The organic material layer of the light emitting layer may include an organic light emitting layer, and may further include a hole injecting/transporting layer and/or an electron injecting/transporting layer.

The cathode electrode 180 may be disposed on the light emitting layer 170. The cathode electrode 180 may be a common electrode that extends across all of the pixels PX. The anode electrode 160, the light emitting layer 170, and the cathode electrode 180 may constitute the organic light emitting element.

The cathode electrode 180 may be in contact with not only the light emitting layer 170, but also a top surface of the bank layer 126. Further, the cathode electrode 180 may be in contact with a surface of the spacer 127, and may cover the surface of the spacer 127 at (e.g., in or on) a region where the spacer 127 is formed. The cathode electrode 180 may be formed to conform to a structure disposed therebelow, to reflect a stepped portion of the structure disposed therebelow.

The cathode electrode 180 may include a material layer having a low work function, for example, such as Li, Ca, LiF/Ca, LiF/Al, Al, Mg, Ag, Pt, Pd, Ni, Au Nd, Ir, Cr, BaF, Ba, or a compound or mixture thereof (e.g., a mixture of Ag and Mg). The cathode electrode 180 may further include a transparent metal oxide layer disposed on the material layer having the low work function.

An anti-reflection member (not shown) and a second substrate 190 are disposed on the cathode electrode 180. The anti-reflection member AR is disposed on the cathode electrode 180, and the second substrate 190 is disposed on the anti-reflection member AR. Because the second substrate 190 has been described above, redundant description thereof may not be repeated.

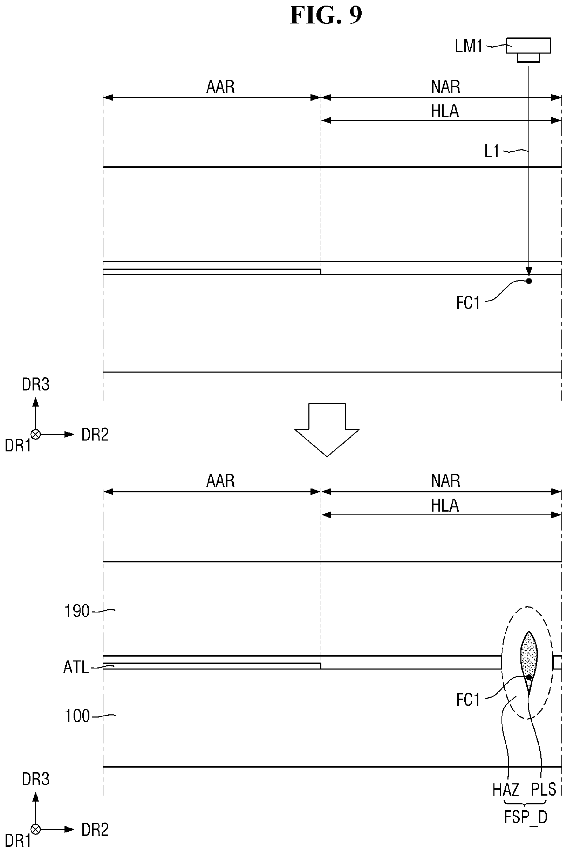

Hereinafter, a method for fabricating a display device 1 according to an embodiment will be described in more detail with reference to FIGS. 9 to 13.

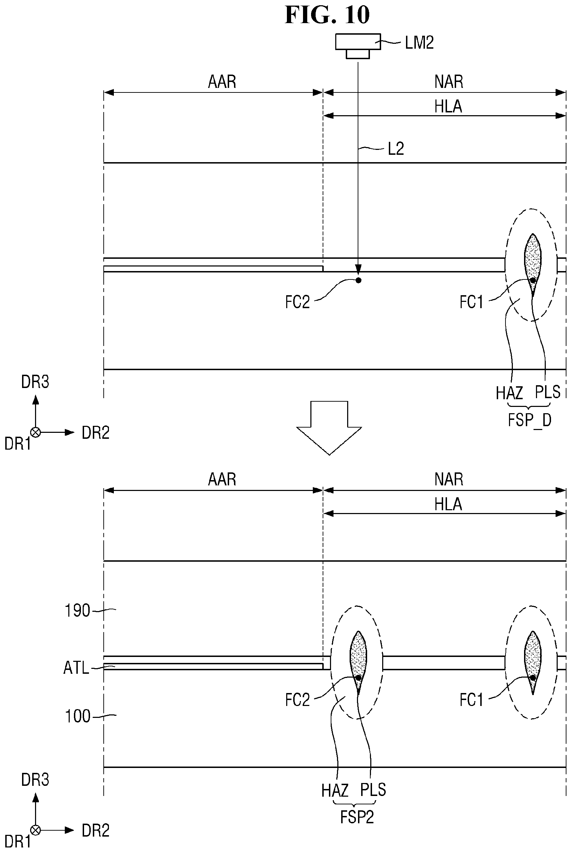

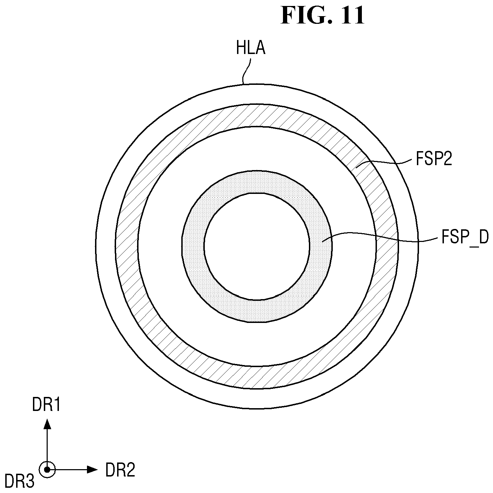

FIGS. 9 and 10 are cross-sectional views for illustrating a method of fabricating a display device according to an embodiment. FIG. 11 is a plan view of a portion around a hole area for illustrating a method of fabricating a display device according to an embodiment. FIGS. 9 and 10 show cross sections of an area around (e.g., surrounding or adjacent to) the hole area HLA. FIG. 9 shows a process of forming a dummy fusion pattern FSP_D, and FIG. 10 shows a process of forming a hole fusion pattern FSP2. FIG. 11 is a plan view showing a portion around (e.g., surrounding or adjacent to) the hole area HLA where the dummy fusion pattern FSP_D and the hole fusion pattern FSP2 are formed.

Referring to FIGS. 9 to 11, the dummy fusion pattern FSP_D and the hole fusion pattern FSP2 for fusing the first substrate 100 and the second substrate 190 to each other are formed. The dummy fusion pattern FSP_D is formed before the hole fusion pattern FSP2 is formed.

In more detail, a first laser module LM1 may emit a first laser beam L1 toward the first substrate 100 from above the second substrate 190. A first focal point FC1 of the first laser beam L1 may be located inside the first substrate 100.

The first laser module LM1 may emit a femtosecond laser beam (or a microwave laser beam). In other words, the first laser beam L1 may be the femtosecond laser beam. As used herein, the femtosecond laser beam may refer to a laser beam having a pulse width greater than or equal to 200 femtoseconds and less than or equal to 500 femtoseconds, but the present disclosure is not limited thereto.

When the first laser beam L1 is irradiated to the first focal point FC1 located inside the first substrate 100, high energy may be provided to a portion around (e.g., adjacent to) the first focal point FC1. The provided energy may turn the first substrate 100 and/or the second substrate 190 into plasma. Parts of the first substrate 100 and/or the second substrate 190 that are turned into plasma may be melted and grown. In other words, a part of the first substrate 100 may grow upward in the thickness direction (e.g., the third direction DR3) up to the second substrate 190, and the first substrate 100 may be fused (or connected) with the second substrate 190. In other words, the first substrate 100 and the second substrate 190 may be connected to each other to form a central portion PLS of the dummy fusion pattern FSP_D.

Heat is generated around the central portion PLS that is turned into plasma, and may melt a portion around (e.g., adjacent to or surrounding) the central portion PLS. Accordingly, the peripheral portion HAZ of the dummy fusion pattern FSP_D may be formed to surround (e.g., around a periphery of) the central portion PLS. The peripheral portion HAZ of the dummy fusion pattern FSP_D may connect the first substrate 100 and the second substrate 190 to each other to bond both components to each other, similarly to the central portion PLS.

Because the peripheral portion HAZ and the central portion PLS have different melting temperatures from each other, optical characteristics thereof may be different from each other. For example, the peripheral portion HAZ and the central portion PLS may have different refractive indices from each other, so that the peripheral portion HAZ and the central portion PLS may be visually distinguished from each other.

A shape of the dummy fusion pattern FSP_D in a cross-sectional view may be the same or substantially the same as that of the edge fusion pattern FSP1 or the hole fusion pattern FSP2 described above, so that redundant description thereof may not be repeated.

The dummy fusion pattern FSP_D may be disposed at (e.g., in or on) the hole area HLA, and may be formed in a circular shape in a plan view. In other words, the first laser beam L1 may be continuously irradiated. Accordingly, the dummy fusion pattern FSP_D may be disposed in a closed curved shape in a plan view. For example, the dummy fusion pattern FSP_D may be formed in a closed circular shape, but the present disclosure is not limited thereto.

In some embodiments, after the dummy fusion pattern FSP_D is formed, a hole fusion pattern FSP2 is formed.

In more detail, a second laser module LM2 may emit a second laser beam L2 toward the first substrate 100 from above the second substrate 190. A second focal point FC2 of the second laser beam L2 may be located inside the first substrate 100. The second laser module LM2 may emit a femtosecond laser beam, and the second laser beam L2 may be a femtosecond laser beam. The second laser beam L2 may be the same or substantially the same as the first laser beam (e.g., see L1 of FIG. 9), but the present disclosure is not limited thereto.

Because a process of forming the hole fusion pattern FSP2 may be the same or substantially the same as the process of forming the dummy fusion pattern FSP_D described above, redundant description thereof may not be repeated.

The hole fusion pattern FSP2 may be formed outside (e.g., to surround a periphery of) the dummy fusion pattern FSP_D while being spaced apart from the dummy fusion pattern FSP_D. The hole fusion pattern FSP2 may be located closer to the active region AAR than the dummy fusion pattern FSP_D. The hole fusion pattern FSP2 may surround (e.g., around a periphery of) the dummy fusion pattern FSP_D.

However, the present disclosure is not limited to the sequence of forming the dummy fusion pattern FSP_D and the hole fusion pattern FSP2. For example, in other embodiments, the hole fusion pattern FSP2 may be formed first, and then the dummy fusion pattern FSP_D may be formed.

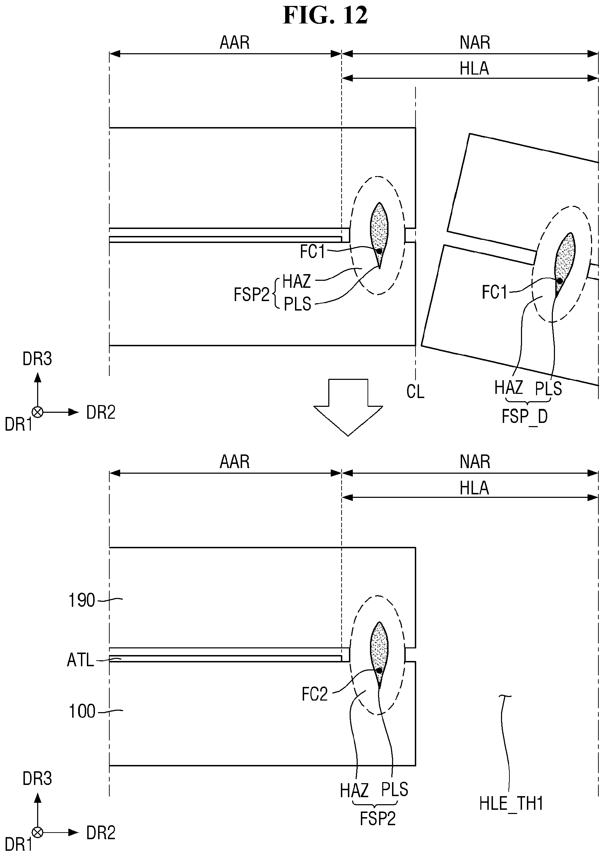

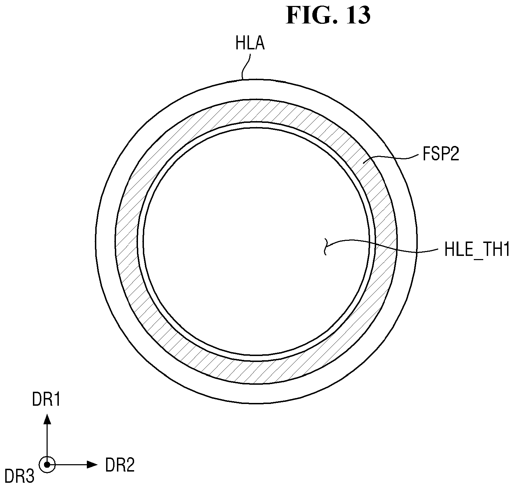

FIG. 12 is a cross-sectional view for illustrating a method of fabricating a display device according to an embodiment. FIG. 13 is a plan view of a portion around a hole area for illustrating a method of fabricating a display device according to an embodiment. FIG. 12 shows a cross section of an area around (e.g., surrounding or adjacent to) the hole area HLA. FIGS. 12 and 13 show a process of forming a first through hole HLE_TH1.

Referring to FIGS. 12 and 13, after the structure shown in FIGS. 10 and 11 is formed, the first through hole HLE_TH1 may be formed by cutting the first substrate 100 and the second substrate 190.

In more detail, the first substrate 100 and the second substrate 190 may be cut along a cutting line CL. For example, the first substrate 100 and the second substrate 190 may be cut by a cutting laser module (e.g., by another cutting laser module) that emits a cutting laser beam (e.g., that emits another cutting laser beam), but the present disclosure is not limited thereto. In the case of forming the first through hole HLE_TH1 by cutting the first substrate 100 and the second substrate 190 using the cutting laser beam, a wavelength of the cutting laser beam may be greater than that of the second laser beam L2 for forming the hole fusion pattern FSP2. The first through hole HLE_TH1 may be formed in the hole area HLA by cutting the first substrate 100 and the second substrate 190. Further, an inner wall of the first through hole HLE_TH1 may include a side surface of the first substrate 100 and a side surface of the second substrate 190, but the present disclosure is not limited thereto. The side surface of the first substrate 100 and the side surface of the second substrate 190 may be aligned (e.g., may be coplanar) with each other.

The cutting line CL may be located between the dummy fusion pattern FSP_D and the hole fusion pattern FSP2. In other words, in the case of forming the first through hole HLE_TH1 by cutting the first substrate 100 and the second substrate 190 along the cutting line CL, the dummy fusion pattern FSP_D may be removed.

Due to the presence of the dummy fusion pattern FSP_D, the first substrate 100 and the second substrate 190 may be more firmly fixed to each other in the process of forming the first through hole HLE_TH1, and a gap between the first substrate 100 and the second substrate 190 in the thickness direction (e.g., the third direction DR3) may be reduced. In the process of cutting the first substrate 100 and the second substrate 190 to form the first through hole HLE_TH1, a stress applied to a portion where the first substrate 100 and the second substrate 190 are fused together may be reduced. Therefore, a distance between the cutting line CL and the hole fusion pattern FSP2 may be further reduced, and the non-active region NAR at (e.g., in or on) the hole area HLA may be further reduced. Further, it may be unnecessary to align the first substrate 100 and the second substrate 190, so that it may be possible to prevent or substantially prevent the non-active region NAR from increasing due to an alignment tolerance.

Although the method of forming the hole fusion pattern FSP2 has been described in more detail above, such method may also be applicable to the method of forming the edge fusion pattern FSP1. In other words, the method of forming the edge fusion pattern FSP1 may be the same or substantially the same as (or similar to) the method of forming the hole fusion pattern FSP2 described above, and thus, redundant description thereof may not be repeated.

Hereinafter, other example embodiments of the display device will be described in more detail. In the following example embodiments, redundant description of the same or substantially the same components as those described above with reference to FIGS. 1-13 may be simplified or may not be repeated, and differences thereof may be mainly described.

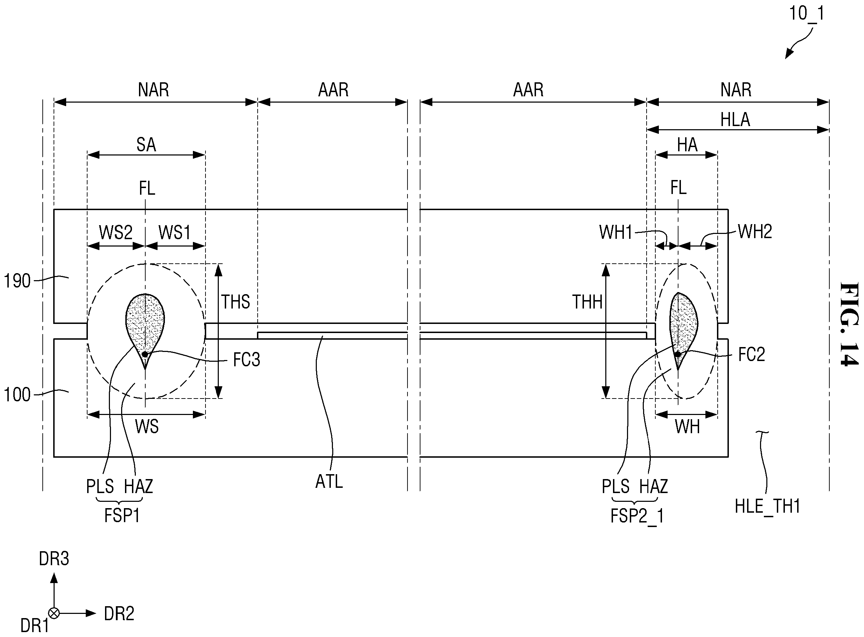

FIG. 14 is a cross-sectional view of a display device according to another embodiment.

Referring to FIG. 14, a width WH of a hole fusion pattern FSP2_1 of a display device 10_1 of the present embodiment may be different from that of the embodiment of FIG. 6, in that the width WH of the hole fusion pattern FSP2_1 in FIG. 14 includes a first width WH1 and a second width WH2 that are different from each other.

In more detail, the width WH of the hole fusion pattern FSP2_1 of the display device 10_1 of the present embodiment may include the first width WH1 and the second width WH2, and the first width WH1 and the second width WH2 may be different from each other. The sum of the first width WH1 and the second width WH2 may be the same as (e.g., may define) the width (e.g., the total width) WH of the hole fusion pattern FSP2_1.

The first width WH1 of the hole fusion pattern FSP2_1 indicates a width of a part of the hole fusion pattern FSP2_1 located at one side of an extension line FL, which is an imaginary line extended from a major axis of the hole fusion pattern FSP2_1 in the thickness direction (e.g., the third direction DR3), and the second width WH2 of the hole fusion pattern FSP2_1 indicates a width of a part of the hole fusion pattern FSP2_1 located at another side (e.g., an opposite side) of the extension line FL. In other words, the one side and the other side of the hole fusion pattern FSP2_1 may be asymmetrical with each other with respect to the extension line FL. A portion of the first width WH1 of the hole fusion pattern FSP2_1 may be distant from (e.g., may be located farther from) the first through hole HLE_TH1 than a portion of the second width WH2 of the hole fusion pattern FSP2_1, and the portion of the first width WH1 of the hole fusion pattern FSP2_1 may be located closer to the active element layer ATL than the portion of the second width WH2 of the hole fusion pattern FSP2_1. The hole fusion pattern FSP2_1 may have a maximum thickness on the extension line FL, and the second focal point FC2 of the hole fusion pattern FSP2_1 may be located on the extension line FL, but the present disclosure is not limited thereto.

The first width WH1 of the hole fusion pattern FSP2_1 may be smaller than the second width WH2 of the hole fusion pattern FSP2_1. The hole fusion pattern FSP2_1 is disposed in a circular shape in a plan view, so that the second focal point FC2 may be moved in a circle in the plan view. Although the same or substantially the same thermal energy may be transferred to the outside and the inside of the circle on which the second focal point FC2 moves, a region where the thermal energy may spread may be smaller inside the circle than outside the circle. Accordingly, the thermal energy may be transferred to a region more distant (e.g., farther) from the second focal point FC2 inside the circle than outside the circle.

On the other hand, the width WS of the edge fusion pattern FSP1 may include a first width WS1 and a second width WS2, and the first width WS1 and the second width WS2 may be the same or substantially the same as each other. The sum of the first width WS1 and the second width WS2 may be the same as (e.g., may define) the width (e.g., the total width) WS of the edge fusion pattern FSP1.

The first width WS1 of the edge fusion pattern FSP1 indicates a width of a region located inside an extension line FL, which is an imaginary line extended from a third focal point FC3 of the edge fusion pattern FSP1 in the thickness direction (e.g., the third direction DR3), and the second width WS2 of the edge fusion pattern FSP1 indicates a width of a region located outside the extension line FL. In other words, a portion of the first width WS1 of the edge fusion pattern FSP1 may be located closer to the active element layer ATL than a portion of the second width WS2 of the edge fusion pattern FSP1.

Further, in the case where the first width WS1 and the second width WS2 of the edge fusion pattern FSP1 are not identical, a difference between the first width WH1 of the hole fusion pattern FSP2_1 and the second width WH2 of the hole fusion pattern FSP2_1 may be greater than a difference between the first width WS1 of the edge fusion pattern FSP1 and the second width WS2 of the edge fusion pattern FSP1. For example, the difference between the first width WH1 of the hole fusion pattern FSP2_1 and the second width WH2 of the hole fusion pattern FSP2_1 may be within a range that is greater than or equal to twice and less than or equal to 5 times the difference between the first width WS1 of the edge fusion pattern FSP1 and the second width WS2 of the edge fusion pattern FSP1, or may be within a range that is greater than or equal to 1.5 times and less than or equal to 10 times the difference between the first width WS1 of the edge fusion pattern FSP1 and the second width WS2 of the edge fusion pattern FSP1, but the present disclosure is not limited thereto.

Further, a region located at one side of the extension line FL of the hole fusion pattern FSP2_1 may have less changes in properties than a region located at the other side of the extension line FL of the hole fusion pattern FSP2_1. Accordingly, a bonding force between the first substrate 100 and the second substrate 190 at (e.g., in or on) the region located at the one side of the extension line FL of the hole fusion pattern FSP2_1 may be greater than a bonding force between the first substrate 100 and the second substrate 190 at (e.g., in or on) the region located at the other side of the extension line FL of the hole fusion pattern FSP2_1.

In this case, the non-active region NAR (or the hole area HLA) around the through hole HLE_TH may be further reduced, which may provide a more immersive display screen to a user.

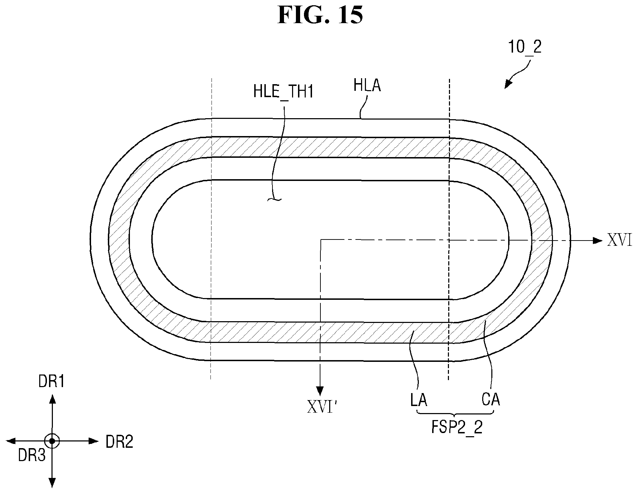

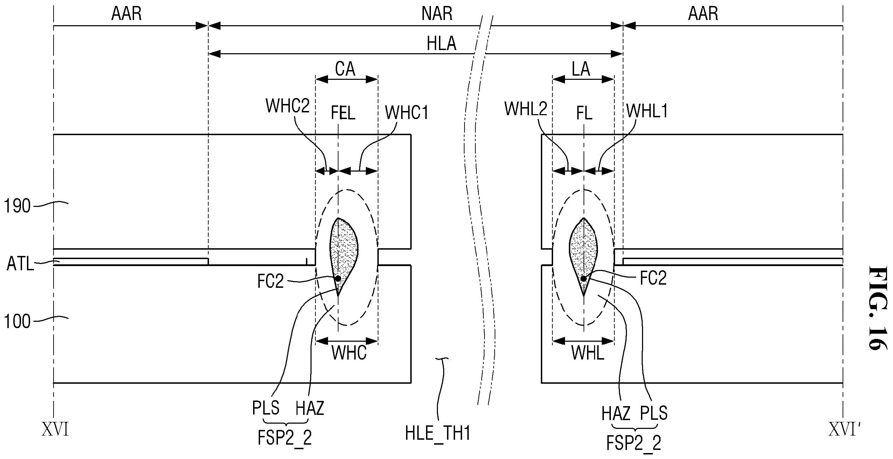

FIG. 15 is an enlarged plan view of a portion around a hole area of a display device according to another embodiment. FIG. 16 is a cross-sectional view taken along the line XVI-XVI' of FIG. 15.

Referring to FIGS. 15 and 16, a hole fusion pattern FSP2_2 of a display device 10_2 of the present embodiment may be different from the hole fusion pattern FSP2_1 of the embodiment of FIG. 14, in that the hole fusion pattern FSP2_2 of the present embodiment includes a linear portion LA and a curved portion CA.

In more detail, the hole fusion pattern FSP2_2 of the display device 10_2 of the present embodiment may include the linear portion LA and the curved portion CA. The linear portion LA of the hole fusion pattern FSP2_2 may be linear in a plan view. For example, the linear portion LA of the hole fusion pattern FSP2_2 may extend in the second direction DR2, but the present disclosure is not limited thereto. The curved portion CA of the hole fusion pattern FSP2_2 may be curved in a plan view. For example, the curved portion CA of the hole fusion pattern FSP2_2 may be disposed as a part of a circumference of a circle in a plan view, but the present disclosure is not limited thereto.

The linear portion LA of the hole fusion pattern FSP2_2 may have a linear portion width WHL, and the linear portion width WHL may include a first width WHL1 and a second width WHL2. The first width WHL1 of the linear portion width WHL is substantially the same as the second width WHL2 of the linear portion width WHL.

The curved portion CA of the hole fusion pattern FSP2_2 may have a curved portion width WHC, and the curved portion width WHC may include a first width WHC1 and a second width WHC2. The first width WHC1 and the second width WHC2 of the curve portion width WHC are different from each other. Because the curved portion width WHC and the first and second widths WHC1 and WHC2 of the curved portion width WHC may be the same or substantially the same as the width WH of the hole fusion pattern FSP2_1 and the second and first widths WH2 and WH1, respectively, of the width WH of the hole fusion pattern FSP2_1 of the embodiment of FIG. 14, redundant description thereof may not be repeated.

In other words, the edge fusion pattern (e.g., see 'FSP1' in FIG. 6), the linear portion LA of the hole fusion pattern FSP2_2, and the curved portion CA of the hole fusion pattern FSP2_2 may be arranged in different shapes from one another. The linear portion width WHL of the linear portion LA of the hole fusion pattern FSP2_2 and the curved portion width WHC of the curved portion CA of the hole fusion pattern FSP2_2 may each be smaller than the width WS of the edge fusion pattern (e.g., see 'FSP1' in FIG. 6). Further, the linear portion width WHL of the linear portion LA of the hole fusion pattern FSP2_2 may include the first width WHL1 and the second width WHL2 that are the same or substantially the same as each other, and the curved portion width WHC of the curved portion CA of the hole fusion pattern FSP2_2 may include the first width WHC1 and the second width WHC2 that are different from each other.

In this case, the non-active region NAR (or the hole area HLA) around (e.g., adjacent to) the through hole HLE_TH may be further reduced, which may provide a more immersive display screen to a user.

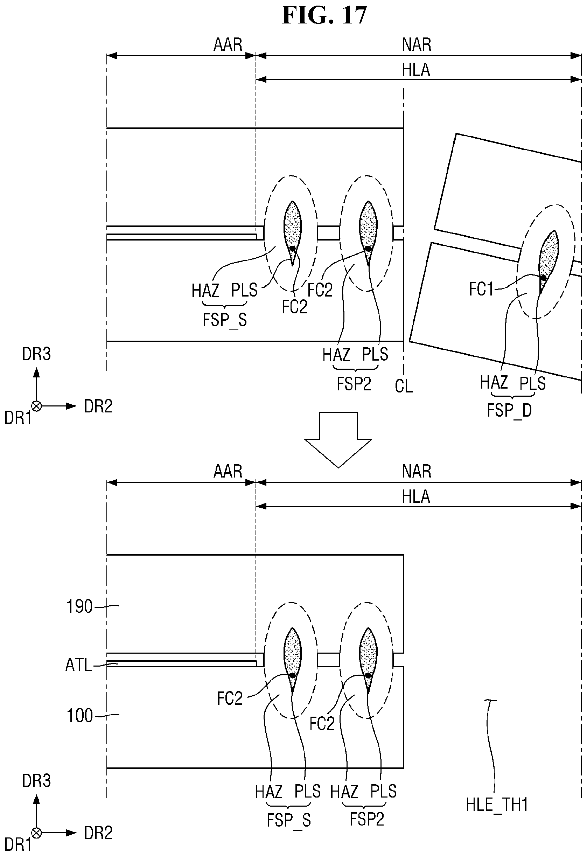

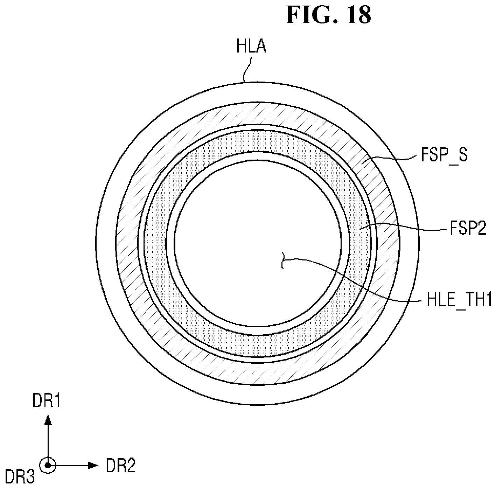

FIG. 17 is a cross-sectional view for illustrating a method of fabricating a display device according to another embodiment. FIG. 18 is an enlarged plan view of a portion around a hole area. FIG. 17 shows a process of forming a sub-hole fusion pattern FSP_S, and then forming a first through hole HLE_TH1. FIG. 18 is a plan view showing a portion around the hole area HLA in which the sub-hole fusion pattern FSP_S is further formed.

Referring to FIGS. 17 and 18, the method of fabricating a display device of the present embodiment may be different from that of the embodiment of FIGS. 9 to 13 in that the sub-hole fusion pattern FSP_S is further formed.

In more detail, the sub-hole fusion pattern FSP_S may be further formed after a dummy fusion pattern FSP_D and a hole fusion pattern FSP2 are formed. The sub-hole fusion pattern FSP_S may be formed at (e.g., in or on) a region that is closer to the active element layer ATL than the hole fusion pattern FSP2. However, the present disclosure is not limited thereto, and the sub-hole fusion pattern FSP_S may be formed at (e.g., in or on) a region that is farther from the active element layer ATL than the hole fusion pattern FSP2.

The method of forming the sub-hole fusion pattern FSP_S may be the same or substantially the same as the method of forming the hole fusion pattern FSP2 or the method of forming the dummy fusion pattern FSP_D described above. Therefore, redundant description thereof may not be repeated.

After the sub-hole fusion pattern FSP_S is formed, the first substrate 100 and the second substrate 190 may be cut along the cutting line CL to thereby form a first through hole HLE_TH1. The cutting line CL may be located between the hole fusion pattern FSP2 and the dummy fusion pattern FSP_D. Therefore, after the first through hole HLE_TH1 is formed, the dummy fusion pattern FSP_D is removed. However, the sub-hole fusion pattern FSP_S and the hole fusion pattern FSP2 may remain around (e.g., surrounding a periphery of) the first through hole HLE_TH1.

In this case, a distance between the cutting line CL and the hole fusion pattern FSP2 may be further reduced, and the non-active region NAR at (e.g., in or on) the hole area HLA may be further reduced. Further, because the sub-hole fusion pattern FSP_S in addition to the hole fusion pattern FSP2 are disposed at (e.g., in or on) the hole area HLA, a bonding force between the first substrate 100 and the second substrate 190 at (e.g., in or on) that region may be increased, and a portion around the through hole HLE_TH1 may be more reliably encapsulated.

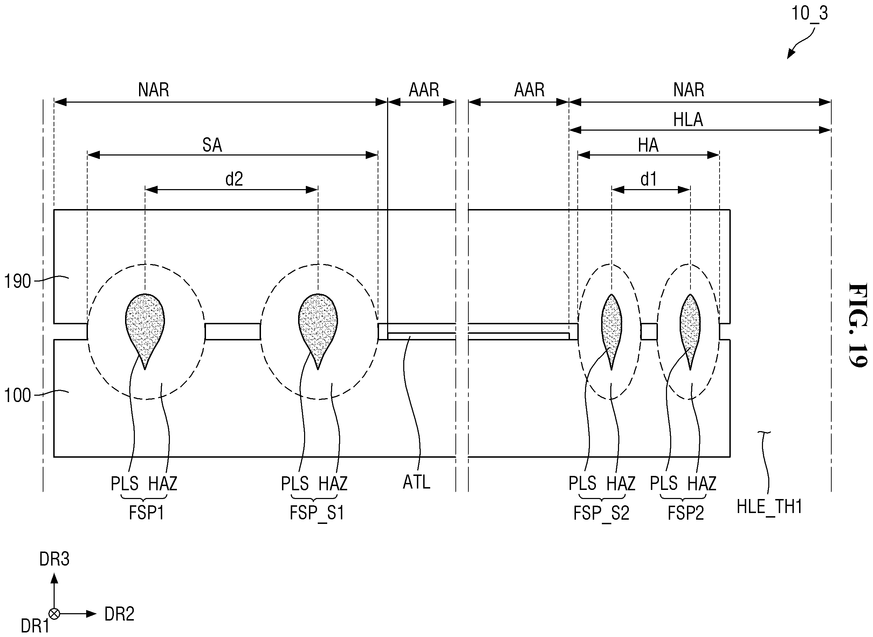

FIG. 19 is a cross-sectional view for illustrating a method of fabricating a display device according to another embodiment. FIG. 19 shows a cross section of a display device 10_3 in which the method of fabricating the display device according to the embodiment of FIGS. 17 and 18 is applied to the substrate encapsulation area SA and the hole encapsulation area HA.

Referring to FIG. 19, the display device 10_3 of the present embodiment may be different from that of the embodiment of FIG. 6 in that the display device 10_3 of the present embodiment includes a first sub-fusion pattern FSP_S1 and a second sub-fusion pattern FSP_S2.

In more detail, the display device 10_3 of the present embodiment includes an edge fusion pattern FSP1, the first sub-fusion pattern FSP_S1, the second sub-fusion pattern FSP_S2, and a hole fusion pattern FSP2.

The first sub-fusion pattern FSP_S1 may be disposed at (e.g., in or on) the substrate encapsulation area SA together with the edge fusion pattern FSP1, and the second sub-fusion pattern FSP_S2 may be disposed at (e.g., in or on) the hole encapsulation area HA together with the hole fusion pattern FSP2. A distance d2 between the first sub-fusion pattern FSP_S1 and the edge fusion pattern FSP1 may be greater than a distance d1 between the second sub-fusion pattern FSP_S2 and the hole fusion pattern FSP2.

In this case, the non-active region NAR (or the hole area HLA) around (e.g., adjacent to) the through hole HLE_TH may be further reduced, which may provide a more immersive display screen to a user. In addition, the bonding force between the first substrate 100 and the second substrate 190 may be increased, and the inner region of the first substrate 100 and the second substrate 190 may be more reliably encapsulated.

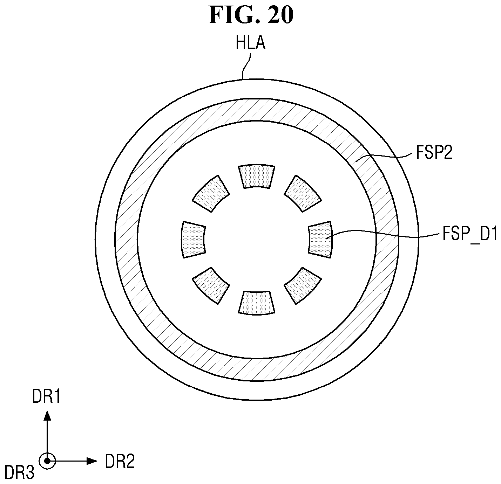

FIG. 20 is a plan view for illustrating a method of fabricating a display device according to another embodiment. FIG. 20 is an enlarged view of a portion around (e.g., adjacent to) a hole area HLA.

Referring to FIG. 20, the method of fabricating a display device according to the present embodiment may be different from the embodiment of FIGS. 9 to 13 in that, in the present embodiment, a dummy fusion pattern FSP_D1 may be divided into multiple parts.

In more detail, in the method of fabricating a display device according to the present embodiment, the dummy fusion pattern FSP_D1 may be formed on a substantially closed curve that is not fully closed. In other words, the dummy fusion pattern FSP_D1 may include multiple parts that are formed separately from each other. In this case, for example a laser beam used for forming the dummy fusion pattern FSP_D1 may not be continuously irradiated.

In this case, the dummy fusion pattern FSP_D1 may still be firmly fixed (e.g., more firmly fixed) to the first substrate 100 and the second substrate 190, and a gap between the first substrate 100 and the second substrate 190 in the thickness direction (e.g., the third direction DR3) may be reduced. In the process of cutting the first substrate 100 and the second substrate 190 to form the first through hole HLE_TH1, stress applied to the portion where the first substrate 100 and the second substrate 190 are fused together may be reduced.

Although some example embodiments have been described, those skilled in the art will readily appreciate that various modifications are possible in the example embodiments without departing from the scope of the appended claims. It will be understood that descriptions of features or aspects within each embodiment should typically be considered as available for other similar features or aspects in other embodiments, unless otherwise described. Thus, as would be apparent to one of ordinary skill in the art, features, characteristics, and/or elements described in connection with a particular embodiment may be used singly or in combination with features, characteristics, and/or elements described in connection with other embodiments unless otherwise specifically indicated. Therefore, it is to be understood that the foregoing is illustrative of various example embodiments and is not to be construed as limited to the specific example embodiments disclosed herein, and that various modifications to the disclosed example embodiments, as well as other example embodiments, are intended to be included within the scope of the present disclosure as defined in the appended claims.

## Claims

1. A display device (1) comprising:
a first substrate (100);
a second substrate (190) facing the first substrate (100);
a through hole (HLE_TH) penetrating the first substrate (100) and the second substrate (190);
a hole fusion pattern (FSP2) formed by fusing the first (100) and second substrates (190) to each other around the through hole (HLE_TH); and
an edge fusion pattern (FSP1) formed by fusing the first (100) and second substrates (190) to each other at an edge of the first substrate (100) or the second substrate (190),
wherein each of the first substrate (100) and the second substrate (190) comprises glass,
wherein a width (WS) of the edge fusion pattern (FSP1) is greater than a width (WH) of the hole fusion pattern (FSP2) in a plan view, and
wherein the display device further comprises a display area for displaying a screen, and a non-display area surrounding the display area,
**characterized in that** the through hole (HLE_TH) and the hole fusion pattern (FSP2) are at the display area, and the edge fusion pattern (FSP1) is at the non-display area, and
wherein the display device (1) further comprises a sub-hole fusion pattern (FSP_S) configured to bond the first (100) and second substrates (190) to each other at the display area, the sub-hole fusion pattern (FSP_S) surrounding at least one of the through hole (HLE_TH) or the hole fusion pattern (FSP2).

2. A display device (1) of claim 1, wherein the width (WH) of the hole fusion pattern (FSP2) is in a range of 1/2 to 1/5 of the width (WS) of the edge fusion pattern (FSP1).

3. A display device (1) of claim 1 or claim 2, wherein the hole fusion pattern (FSP2) is between the first substrate (100) and the second substrate (190).

4. A display device (1) of any one of claims 1 to 3, further comprising an active element layer (ATL) between the first substrate (100) and the second substrate (190),
wherein the active element layer (ATL) does not overlap with the through hole (HLE_TH).

5. A display device (1) of any one of claims 1 to 4, wherein the hole fusion pattern (FSP2) comprises a central portion (PLS) including a plasma structure, and a peripheral portion (HAZ) surrounding the central portion (PLS).

6. A display device (1) of claim 5, wherein a ratio of a thickness of the hole fusion pattern (FSP2) in a thickness direction (DR3) to a width (WH) of the hole fusion pattern (FSP2) in a first direction (DR2) perpendicular to the thickness direction (DR3) is greater than 1.9:1, optionally wherein the width (WH) of the hole fusion pattern (FSP2) in the first direction (DR2) is less than or equal to 100 µm.

7. A display device (1) of claim 5 or claim 6, wherein the hole fusion pattern (FSP2) further comprises a long axis and a short axis crossing the long axis, and
wherein a width of one side of the long axis in a direction of the short axis is different from a width of another side of the long axis in the direction of the short axis, optionally wherein the other side of the long axis is closer to the through hole (HLE_TH) than the one side of the long axis, and
the width of the other side of the long axis is greater than the width of the one side of the long axis.

8. A display device (1) of any one of claims 1 to 7, wherein the through hole (HLE_TH) and the hole fusion pattern (FSP2) are spaced apart from each other, and the first substrate (100) and the second substrate (190) are spaced apart from each other in a thickness direction (DR3) at a region where the through hole (HLE_TH) and the hole fusion pattern (FSP2) are spaced apart from each other.

9. A method of fabricating a display device (1), comprising:
placing a second substrate (190) on a first substrate (100) on which an active element layer (ATL) is disposed;
forming a dummy fusion pattern (FSP_D) and a hole fusion pattern (FSP2) by fusing the first (100) and second substrates (190) to each other by irradiating a femtosecond laser beam onto at least one of the first (100) and second substrates (190), the dummy fusion pattern (FSP_D) being disposed on a first closed curve, and the hole fusion pattern (FSP2) being disposed on a second closed curve that is spaced apart from the first closed curve and outside the first closed curve; and
forming a through hole (HLE_TH) penetrating the first substrate (100) and the second substrate (190) in a thickness direction (DR3) by cutting the first substrate (100) and the second substrate (190) between the dummy fusion pattern (FSP_D) and the hole fusion pattern (FSP2).

10. A method of claim 9, wherein the hole fusion pattern (FSP2) is continuously formed without being disconnected, and the dummy fusion pattern (FSP_D) is formed into a plurality of parts by being at least partially disconnected.

11. A method of claim 9 or claim 10, wherein:
(i) the forming of the dummy fusion pattern (FSP_D) and the hole fusion pattern (FSP2) comprises:
forming a sub-hole fusion pattern (FSP_S) on a third closed curve that is spaced apart from the second closed curve and outside the second closed curve; and/or
(ii) the forming of the through hole (HLE_TH) comprises irradiating a cutting laser beam to at least one of the first (100) and second substrates (190), and
wherein a wavelength of the cutting laser beam is greater than a wavelength of the femtosecond laser beam; and/or
(iii) each of the first substrate (100) and the second substrate (190) comprises glass.

## Patentansprüche

1. Anzeigevorrichtung (1), die Folgendes umfasst:
ein erstes Substrat (100),
ein zweites Substrat (190), das dem ersten Substrat (100) gegenüberliegt,
ein Durchgangsloch (HLE_TH), welches das erste Substrat (100) und das zweite Substrat (190) durchdringt,
ein Lochverschmelzungsmuster (FSP2), das durch Verschmelzen des ersten (100) und des zweiten Substrats (190) miteinander um das Durchgangsloch (HLE_TH) geformt ist, und
ein Kantenverschmelzungsmuster (FSP1), das durch Verschmelzen des ersten (100) und des zweiten Substrats (190) miteinander an einer Kante des ersten Substrats (100) oder des zweiten Substrats (190) geformt ist,
wobei jedes des ersten Substrat (100) und des zweiten Substrats (190) Glas umfasst,
wobei eine Breite (WS) des Kantenverschmelzungsmusters (FSP1) größer ist als eine Breite (WH) des Lochverschmelzungsmusters (FSP2) in einer Draufsicht und
wobei die Anzeigevorrichtung ferner einen Anzeigebereich zum Anzeigen eines Bildschirms und einen Nichtanzeigebereich, der den Anzeigebereich umgibt, umfasst,
**dadurch gekennzeichnet, dass** sich das Durchgangsloch (HLE_TH) und das Lochverschmelzungsmuster (FSP2) bei dem Anzeigebereich befinden und sich das Kantenverschmelzungsmuster (FSP1) bei dem Nichtanzeigebereich befindet, und
wobei die Anzeigevorrichtung (1) ferner ein Teillochverschmelzungsmuster (FSP-S) umfasst, das dafür konfiguriert ist, das erste (100) und das zweite Substrat (190) bei dem Anzeigebereich aneinander zu binden, wobei das Teillochverschmelzungsmuster (FSP-S) mindestens eines von dem Durchgangsloch (HLE_TH) oder dem Lochverschmelzungsmuster (FSP2) umgibt.

2. Anzeigevorrichtung (1) nach Anspruch 1, wobei die Breite (WH) des Lochverschmelzungsmusters (FSP2) in einem Bereich von 1/2 bis 1/5 der Breite (WS) des Kantenverschmelzungsmusters (FSP1) liegt.

3. Anzeigevorrichtung (1) nach Anspruch 1 oder Anspruch 2, wobei sich das Lochverschmelzungsmuster (FSP2) zwischen dem ersten Substrat (100) und dem zweiten Substrat (190) befindet.

4. Anzeigevorrichtung (1) nach einem der Ansprüche 1 bis 3, die ferner eine Aktivelementschicht (ATL) zwischen dem ersten Substrat (100) und dem zweiten Substrat (190) umfasst,
wobei sich die Aktivelementschicht (ATL) nicht mit dem Durchgangsloch (HLE_TH) überlappt.

5. Anzeigevorrichtung (1) nach einem der Ansprüche 1 bis 4, wobei das Lochverschmelzungsmuster (FSP2) einen mittigen Abschnitt (PLS), der eine Plasmastruktur einschließt, und einen Umfangsabschnitt (HAZ), der den mittigen Abschnitt (PLS) umgibt, umfasst.

6. Anzeigevorrichtung (1) nach Anspruch 5, wobei ein Verhältnis einer Dicke des Lochverschmelzungsmusters (FSP2) in einer Dickenrichtung (DR3) zu einer Breite (WH) des Lochverschmelzungsmusters (FSP2) in einer ersten Richtung (DR2), senkrecht zu der Dickenrichtung (DR3), größer als 1,9:1 ist, wahlweise, wobei die Breite (WH) des Lochverschmelzungsmusters (FSP2) in der ersten Richtung (DR2) kleiner als oder gleich 100 µm ist.

7. Anzeigevorrichtung (1) nach Anspruch 5 oder Anspruch 6, wobei das Lochverschmelzungsmuster (FSP2) ferner eine lange Achse und eine kurze Achse, welche die lange Achse kreuzt, umfasst, und
wobei sich eine Breite einer Seite der langen Achse in einer Richtung der kurzen Achse von einer Breite einer anderen Seite der langen Achse in der Richtung der kurzen Achse unterscheidet, wahlweise, wobei die andere Seite der langen Achse dem Durchgangsloch (HLE_TH) näher ist als die eine Seite der langen Achse, und
die Breite der anderen Seite der langen Achse größer ist als die Breite der einen Seite der langen Achse.

8. Anzeigevorrichtung (1) nach einem der Ansprüche 1 bis 7, wobei das Durchgangsloch (HLE_TH) und das Lochverschmelzungsmuster (FSP2) voneinander beabstandet sind und das erste Substrat (100) und das zweite Substrat (190) bei einem Bereich, wo das Durchgangsloch (HLE_TH) und das Lochverschmelzungsmuster (FSP2) voneinander beabstandet sind, in einer Dickenrichtung (DR3) voneinander beabstandet sind.

9. Verfahren zum Fertigen einer Anzeigevorrichtung (1), das Folgendes umfasst:
Platzieren eines zweiten Substrats (190) auf einem ersten Substrat (100), auf dem eine Aktivelementschicht (ATL) angeordnet ist,
Formen eines Platzhalter-Fusionsmusters (FSP _D) und eines Lochverschmelzungsmusters (FSP2) durch Verschmelzen des ersten (100) und des zweiten Substrats (190) miteinander durch Strahlen eines Femtosekunden-Laserstrahls auf mindestens eines von dem ersten (100) und dem zweiten Substrat (190), wobei das Platzhalter-Fusionsmuster (FSP_D) auf einer ersten geschlossenen Kurve angeordnet ist und das Lochverschmelzungsmuster (FSP2) auf einer zweiten geschlossenen Kurve angeordnet ist, die von der ersten geschlossenen Kurve beabstandet ist und sich außerhalb der ersten geschlossenen Kurve befindet, und
Formen eines Durchgangslochs (HLE_TH), welches das erste Substrat (100) und das zweite Substrat (190) in einer Dickenrichtung (DR3) durchdringt, durch Schneiden des ersten Substrats (100) und des zweiten Substrats (190) zwischen dem Platzhalter-Fusionsmuster (FSP_D) und dem Lochverschmelzungsmuster (FSP2).

10. Verfahren nach Anspruch 9, wobei das Lochverschmelzungsmuster (FSP2) durchgehend geformt wird, ohne dass es unterbrochen wird, und das Platzhalter-Fusionsmuster (FSP _D) dadurch, dass es mindestens teilweise unterbrochen wird, zu einer Vielzahl von Teilen geformt wird.

11. Verfahren nach Anspruch 9 oder Anspruch 10, wobei:
(i) das Formen des Platzhalter-Fusionsmusters (FSP _D) und des Lochverschmelzungsmusters (FSP2) Folgendes umfasst:
Formen eines Teillochverschmelzungsmusters (FSP-S) auf einer dritten geschlossenen Kurve, die von der zweiten geschlossenen Kurve beabstandet ist und sich außerhalb der zweiten geschlossenen Kurve befindet, und/oder
(ii) das Formen des Durchgangslochs (HLE_TH) das Strahlen eines Schneidlaserstrahls auf mindestens eines von dem ersten (100) und dem zweiten Substrat (190) umfasst und
wobei eine Wellenlänge des Schneidlaserstrahls größer ist als eine Wellenlänge des Femtosekunden-Laserstrahls und/oder
(iii) jedes des ersten Substrats (100) und des zweiten Substrats (190) Glas umfasst.

## Revendications

1. Dispositif d'affichage (1) comprenant :
un premier substrat (100) ;
un second substrat (190) qui fait face au premier substrat (100) ;
un trou traversant (HLE_TH) qui pénètre le premier substrat (100) et le second substrat (190) ;
un motif de fusion par trou (FSP2) formé en fusionnant les premier (100) et second (190) substrats l'un à l'autre autour du trou traversant (HLE_TH) ; et
un motif de fusion par bord (FSP1) formé en fusionnant les premier (100) et second (190) substrats l'un à l'autre au niveau d'un bord du premier substrat (100) ou du second substrat (190),
dans lequel chacun du premier substrat (100) et du second substrat (190) comprend du verre,
dans lequel une largeur (WS) du motif de fusion par bord (FSP1) est plus grande qu'une largeur (WH) du motif de fusion par trou (FSP2) selon une vue en plan, et
dans lequel le dispositif d'affichage comprend en outre une zone d'affichage pour afficher un écran et une zone de non affichage qui entoure la zone d'affichage,
**caractérisé en ce que** le trou traversant (HLE_TH) et le motif de fusion par trou (FSP2) sont au niveau de la zone d'affichage, et le motif de fusion par bord (FSP1) est au niveau de la zone de non affichage, et
dans lequel le dispositif d'affichage (1) comprend en outre un motif de fusion par sous-trou (FSP_S) configuré pour lier les premier (100) et second (190) substrats l'un à l'autre au niveau de la zone d'affichage, le motif de fusion par sous-trou (FSP_S) entourant au moins l'un du trou traversant (HLE_TH) ou du motif de fusion par trou (FSP2).

2. Dispositif d'affichage (1) selon la revendication 1, dans lequel la largeur (WH) du motif de fusion par trou (FSP2) est dans une plage de 1/2 à 1/5 fois la largeur (WS) du motif de fusion par bord (FSP1).

3. Dispositif d'affichage (1) selon la revendication 1 ou la revendication 2, dans lequel le motif de fusion par trou (FSP2) est entre le premier substrat (100) et le second substrat (190).

4. Dispositif d'affichage (1) selon l'une quelconque des revendications 1 à 3, comprenant en outre une couche d'élément actif (ATL) entre le premier substrat (100) et le second substrat (190),
dans lequel la couche d'élément actif (ATL) ne chevauche pas le trou traversant (HLE TH).

5. Dispositif d'affichage (1) selon l'une quelconque des revendications 1 à 4, dans lequel le motif de fusion par trou (FSP2) comprend une section centrale (PLS) incluant une structure plasmatique, et une section périphérique (HAZ) entourant la section centrale (PLS).

6. Dispositif d'affichage (1) selon la revendication 5, dans lequel un rapport d'une épaisseur du motif de fusion par trou (FSP2) dans une direction de l'épaisseur (DR3) sur une largeur (WH) du motif de fusion par trou (FSP2) dans une première direction (DR2) perpendiculaire à la direction de l'épaisseur (DR3) est supérieur à 1,9:1, facultativement dans lequel la largeur (WH) du motif de fusion par trou (FSP2) dans la première direction (DR2) est inférieure ou égale à 100 µm.

7. Dispositif d'affichage (1) selon la revendication 5 ou la revendication 6, dans lequel le motif de fusion par trou (FSP2) comprend en outre un axe long et un axe court qui croise l'axe long, et
dans lequel une largeur d'un premier côté de l'axe long dans une direction de l'axe court est différente d'une largeur d'un autre côté de l'axe long dans la direction de l'axe court, facultativement dans lequel l'autre côté de l'axe long est plus près du trou traversant (HLE _TH) que le premier côté de l'axe long, et
la largeur de l'autre côté de l'axe long est plus grande que la largeur du premier côté de l'axe long.

8. Dispositif d'affichage (1) selon l'une quelconque des revendications 1 à 7, dans lequel le trou traversant (HLE_TH) et le motif de fusion par trou (FSP2) sont espacés l'un de l'autre, et le premier substrat (100) et le second substrat (190) sont espacés l'un de l'autre dans une direction de l'épaisseur (DR3) au niveau d'une région où le trou traversant (HLE_TH) et le motif de fusion par trou (FSP2) sont espacés l'un de l'autre.

9. Procédé de fabrication d'un dispositif d'affichage (1), comprenant :
le positionnement d'un second substrat (190) sur un premier substrat (100) sur lequel une couche d'éléments actif (ATL) est disposée ;
la formation d'un motif de fusion fictif (FSP_D) et d'un motif de fusion par trou (FSP2) en fusionnant l'un à l'autre les premier (100) et second (190) substrats en irradiant un faisceau laser femtoseconde sur au moins l'un des premier (100) et second (190) substrats, le motif de fusion fictif (FSP_D) étant disposé sur une première courbe fermée, et le motif de fusion par trou (FSP2) étant disposé sur une deuxième courbe fermée qui est espacée de la première courbe fermée et à l'extérieur de la première courbe fermée ; et
la formation d'un trou traversant (HLE_TH) qui pénètre le premier substrat (100) et le second substrat (190) dans une direction de l'épaisseur (DR3) en coupant le premier substrat (100) et le second substrat (190) entre le motif de fusion fictif (FSP_D) et le motif de fusion par trou (FSP2).

10. Procédé selon la revendication 9, dans lequel le motif de fusion par trou (FSP2) est formé en continu sans être interrompu, et le motif de fusion fictif (FSP_D) est formé en une pluralité de parties en étant au moins partiellement interrompu.

11. Procédé selon la revendication 9 ou la revendication 10, dans lequel :
(i) la formation du motif de fusion fictif (FSP_D) et du motif de fusion par trou (FSP2) comprend :
la formation d'un motif de fusion par sous-trou (FSP_S) sur une troisième courbe fermée qui est espacée de la deuxième courbe fermée et à l'extérieur de la deuxième courbe fermée ; et/ou
(ii) la formation du trou traversant (HLE_TH) comprend l'irradiation d'un faisceau laser de coupe sur au moins l'un des premier (100) et second (190) substrats, et
dans lequel une longueur d'onde du faisceau laser de coupe est plus grande qu'une longueur d'onde du faisceau laser femtoseconde ; et/ou
(iii) chacun du premier substrat (100) et du second substrat (190) comprend du verre.
